# EUROPEAN PATENT SPECIFICATION

(11) **EP 3 170 206 B1**
(45) Date of publication and mention of the grant of the patent: **15.03.2023**
(21) Application number: 15821623.4
(22) Date of filing: 17.07.2015
(51) Int. Cl.: H01L 51/54, C09K 11/06

(54) **ORGANIC ELECTROLUMINESCENT DEVICE**
ORGANISCHE ELEKTROLUMINESZENZVORRICHTUNG
DISPOSITIF ÉLECTROLUMINESCENT ORGANIQUE

(30) Priority: 18.07.2014 KR 20140091068
(43) Date of publication of application: 24.05.2017
(73) Proprietor: Rohm And Haas Electronic Materials Korea Ltd., Chungcheongnam-do 331-980 (KR)
(72) Inventor: PARK, Kyoung-Jin, Seongnam-si Gyeonggi-do 462-838 (KR); LEE, Tae-Jin, Seongnam-si Gyeonggi-do 462-827 (KR); DOH, Yoo-Jin, Gwacheon-si Gyeonggi-do 427-731 (KR); AHN, Hee-Choon, Suwon-si Gyeonggi-do 443-400 (KR); KIM, Young-Kwang, Suwon-si Gyeonggi-do 443-814 (KR); MOON, Doo-Hyeon, Hwaseong-si Gyeonggi-do 445-768 (KR); YANG, Jeong-Eun, Suwon-si Gyeonggi-do 442-870 (KR); LEE,Su-Hyun, Suwon-si Gyeonggi-do 440-200 (KR); KIM, Chi-Sik, Hwaseong-si Gyeonggi-do 445-752 (KR); JUN, Ji-Song, Cheonan-si Chungcheongnam-do 331-980 (KR); SHIM, Jae-Hoon, Cheonan-si Chungcheongnam-do 331-980 (KR)
(74) Representative: Houghton, Mark Phillip
(86) International application number: PCT/KR2015/007462
(87) International publication number: WO 2016/010402

(56) References cited:
- WO-A1-2013/062075
- WO-A1-2013/187896
- WO-A1-2014/094963
- DE-A1-102013 208 844
- US-A1- 2013 234 119
- US-A1- 2013 313 536
- US-A1- 2013 320 368
- US-A1- 2014 042 469
- US-A1- 2014 340 888

## Description

### Technical Field

The present disclosure relates to an organic electroluminescent device.

### Background Art

An electroluminescent (EL) device is a self-light-emitting device which has advantages in that it provides a wider viewing angle, a greater contrast ratio, and a faster response time. An organic EL device was first developed by Eastman Kodak, by using small aromatic diamine molecules and aluminum complexes as materials to form a light-emitting layer [Appl. Phys. Lett. 51, 913, 1987].

The organic EL device converts electric energy into light when electricity is applied to an organic light-emitting material(s). Generally, the organic EL device has a structure comprising an anode, a cathode, and an organic layer disposed between the anode and the cathode. The organic layer of the organic EL device comprises a hole injection layer, a hole transport layer, an electron blocking layer, a light-emitting layer, an electron buffering layer, a hole blocking layer, an electron transport layer, an electron injection layer, etc. Depending on its function, materials for forming the organic layer can be classified as a hole injection material, a hole transport material, an electron blocking material, a light-emitting material, an electron buffering material, a hole blocking material, an electron transport material, an electron injection material, etc. When a voltage is applied to the organic EL device, holes and electrons are injected from an anode and a cathode, respectively, to the light-emitting layer. Excitons having high energy are formed by recombinations between the holes and the electrons. The energy of excitons puts the light-emitting organic compound in an excited state, and the decay of the excited state results in a relaxation of the energy level into a ground state, accompanied by light-emission.

The most important factor determining luminous efficiency in the organic EL device is light-emitting materials. The light-emitting material needs to have high quantum efficiency, high electron mobility, and high hole mobility. Furthermore, the light-emitting layer formed by the light-emitting material needs to be uniform and stable. Depending on colors visualized by light-emission, the light-emitting materials can be classified as a blue-, green-, or red-emitting material, and a yellow- or orange-emitting material can be additionally included therein. Depending on its function, the light-emitting materials can be classified as a host material and a dopant material. Recently, the development of an organic EL device providing high efficiency and long lifespan is an urgent issue. Particularly, considering EL characteristic requirements for a middle or large-sized panel of OLED, materials showing better characteristics than conventional ones must be urgently developed. The host material acts as a solvent in a solid state and transfers energy, and thus needs to have high purity and a molecular weight appropriate for vacuum deposition. Furthermore, the host material needs to have high glass transition temperature and high thermal degradation temperature to achieve thermal stability; high electro-chemical stability to achieve long lifespan; easiness of forming amorphous thin film; good adhesion to materials of adjacent layers; and non-migration to other layers.

In order to enhance color purity, luminous efficiency and stability, the light-emitting material may be used as a mixture of a host and a dopant. Generally, devices showing good electroluminescent characteristics have a structure comprising a light-emitting layer in which a dopant is doped into a host. In the dopant/host material system, efficiency and lifespan of the device are highly affected by the host material, and thus selection of the host material is important.

DE102013208844A1 discloses a light-emitting element comprising a plurality of light-emitting units which are separated from one another by a charge generation layer. The light-emitting units each have a light-emitting layer which is featured by a stack of two layers. Each of the two layers includes a host material and a phosphorescent material where the phosphorescent material in one of the two layers is blue emissive while the phosphorescent material in the other of the two layers exhibits a maximum emission peak in a range from 500 nm to 700 nm. WO2013/187896A1 discloses an organic electroluminescence device utilizes a novel combination comprising one or more biscarbazole derivative compounds as the phosphorescent host material in combination with a green phosphorescent dopant material in the light emitting region of the device. WO2013/062075A1 discloses an organic electroluminescence element equipped with at least an light-emitting layer between an anode and a cathode, wherein the organic electroluminescence element is characterized in that the light-emitting layer includes a first host material, a second host material, and a phosphorescent light-emissive dopant material. WO 2013/168688 A1, WO 2009/060757 A1, and Japanese Patent Application Laying-Open No. 2013-183036 A disclose an organic electroluminescent device employing a biscarbazole derivative as a host material. However, they fail to specifically disclose an organic electroluminescent device employing, as a plurality of host materials, a biscarbazole derivative in which the nitrogen atoms of the carbazoles are linked to aryls, respectively, and a carbazole derivative in which the nitrogen atom of the carbazole is linked to a nitrogen-containing heteroaryl, and as a hole transport material, a biscarbazole derivative in which the nitrogen atoms of the carbazoles are linked to aryls, respectively.

### Disclosure of the Invention

### Problems to be Solved

The object of the present disclosure is to provide an organic electroluminescent device showing high efficiency and long lifespan.

### Solution to Problems

The invention is set out in accordance with the appended claims. The present inventors found that the above object can be achieved by an organic electroluminescent device comprising an anode, a cathode, and an organic layer between the anode and the cathode, wherein the organic layer comprises one or more light-emitting layers and one or more hole transport layers; at least one of the one or more light-emitting layers comprises one or more dopant compounds and two or more host compounds; a first host compound of the host compounds is represented by the following formula 1; a second host compound is represented by the following formula 2; and at least one of the one or more hole transport layers comprises the compound represented by the following formula 1: 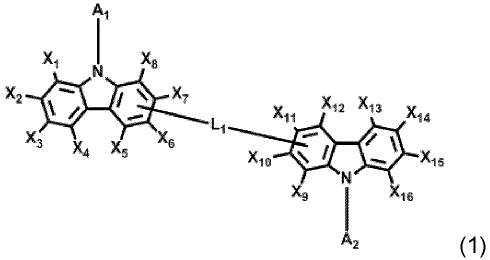 wherein
A₁ and A₂, each independently, represent a substituted or unsubstituted (C6-C30)aryl, provided that a nitrogen-containing heteroaryl is excluded from the substituent of A₁ and A₂;
L₁ represents a single bond or a substituted or unsubstituted (C6-C30)arylene;
X₁ to X₁₆, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3-to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino; or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur; 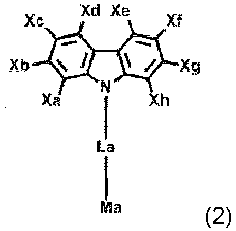
wherein
Ma represents a substituted or unsubstituted monocyclic ring-type heteroaryl selected from the group consisting of a substituted or unsubstituted pyrrolyl, a substituted or unsubstituted imidazolyl, a substituted or unsubstituted pyrazolyl, a substituted or unsubstituted triazinyl, a substituted or unsubstituted tetrazinyl, a substituted or unsubstituted triazolyl, a substituted or unsubstituted tetrazolyl, a substituted or unsubstituted pyrazinyl, a substituted or unsubstituted pyrimidinyl, and a substituted or unsubstituted pyridazinyl, or a substituted or unsubstituted fused ring-type heteroaryl selected from the group consisting of a substituted or unsubstituted benzimidazolyl, a substituted or unsubstituted isoindolyl, a substituted or unsubstituted indolyl, a substituted or unsubstituted indazolyl, a substituted or unsubstituted benzothiadiazolyl, a substituted or unsubstituted quinolyl, a substituted or unsubstituted isoquinolyl, a substituted or unsubstituted cinnolinyl, a substituted or unsubstituted quinazolinyl, a substituted or unsubstituted naphthyridinyl, and a substituted or unsubstituted quinoxalinyl;
La represents a single bond, or a substituted or unsubstituted (C6-C30)arylene;
Xa, and Xc to Xh, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino;
Xb represents a substituted or unsubstituted dibenzofurayl or a substituted or unsubstituted dibenzothiophenyl; and
the heteroaryl contains at least one hetero atom selected from B, N, O, S, Si, and P.

### Effects of the Invention

According to the present disclosure, an organic electroluminescent device having high efficiency and long lifespan is provided. In addition, the organic electroluminescent device of the present disclosure can be used for the manufacture of a display system or a lighting system.

### Embodiments of the Invention

Hereinafter, the present disclosure will be described in detail. However, the following description is intended to explain the invention, and is not meant in any way to restrict the scope of the invention. The scope of the invention is defined by the appended claims.

The details of the organic electroluminescent device of the present disclosure are as follows.

According to one embodiment of the organic electroluminescent device of the present disclosure, the compound of formula 1 may be represented by any one of the following formulae 3, 4, 5, and 6. 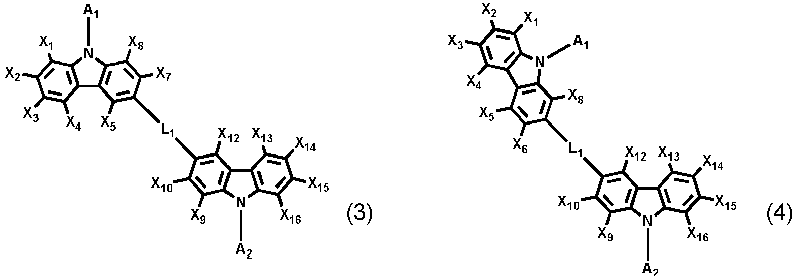 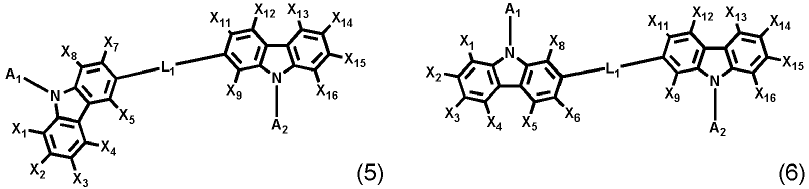 wherein A₁, A₂, L₁ and X₁ to X₁₆ are as defined in formula 1 above.

In formula 1, A₁ and A₂, each independently, represent a substituted or unsubstituted (C6-C30)aryl. A₁ and A₂, each independently, may represent preferably, a substituted or unsubstituted (C6-C18)aryl; and more preferably, a (C6-C18)aryl unsubstituted or substituted with a cyano, a halogen, a (C1-C6)alkyl, a (C6-C12)aryl, or a tri(C6-C12)arylsilyl. Specifically, A₁ and A₂, each independently, may be selected from the group consisting of a substituted or unsubstituted phenyl, a substituted or unsubstituted biphenyl, a substituted or unsubstituted terphenyl, a substituted or unsubstituted naphthyl, a substituted or unsubstituted fluorenyl, a substituted or unsubstituted benzofluorenyl, a substituted or unsubstituted phenanthrenyl, a substituted or unsubstituted anthracenyl, a substituted or unsubstituted indenyl, a substituted or unsubstituted triphenylenyl, a substituted or unsubstituted pyrenyl, a substituted or unsubstituted tetracenyl, a substituted or unsubstituted perylenyl, a substituted or unsubstituted chrysenyl, a substituted or unsubstituted phenylnaphthyl, a substituted or unsubstituted naphthylphenyl, and a substituted or unsubstituted fluoranthenyl. Herein, the substituents of the substituted phenyl, etc., may be a cyano, a halogen, a (C1-C6)alkyl, a (C6-C12)aryl, or a tri(C6-C12)arylsilyl.

In formula 1, X₁ to X₁₆, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino, or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur. Preferably, X₁ to X₁₆. each independently, may represent hydrogen, a cyano, a substituted or unsubstituted (C1-C10)alkyl, a substituted or unsubstituted (C6-C20)aryl, a substituted or unsubstituted 5- to 20-membered heteroaryl, or a substituted or unsubstituted tri(C6-C12)arylsilyl. More preferably, X₁ to X₁₆. each independently, may represent hydrogen; a cyano; a (C1-C10)alkyl; a (C6-C20)aryl unsubstituted or substituted with a cyano, a (C1-C10)alkyl, or a tri(C6-C12)arylsilyl; a 5- to 20-membered heteroaryl unsubstituted or substituted with a (C1-C10)alkyl, a (C6-C15)aryl or a tri(C6-C12)arylsilyl; or a tri(C6-C12)arylsilyl unsubstituted or substituted with a (C1-C10)alkyl. Specifically, X₁ to X₁₆. each independently, may represent hydrogen; a cyano; a (C1-C6)alkyl; phenyl, biphenyl, terphenyl, or naphthyl, unsubstituted or substituted with a cyano, a (C1-C6)alkyl or triphenylsilyl; dibenzothiophene or dibenzofuran, unsubstituted or substituted with a (C1-C6)alkyl, phenyl, biphenyl, naphthyl, or triphenylsilyl; or triphenylsilyl unsubstituted or substituted with a (C1-C6)alkyl.

In formula 1, L₁ represents a single bond, or a substituted or unsubstituted (C6-C30)arylene. Preferably, L₁ may represent a single bond, or a substituted or unsubstituted (C6-C 15)arylene.

L₁ may represent a single bond, or one selected from the following formulae 7 to 19. 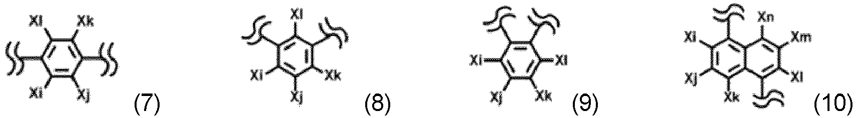 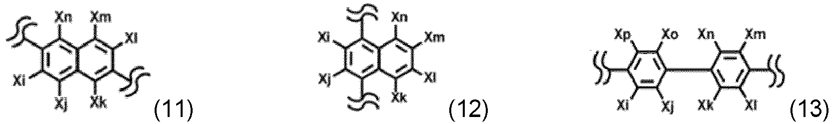 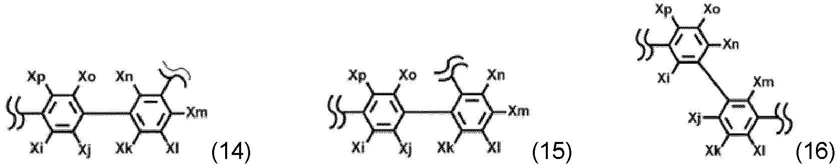 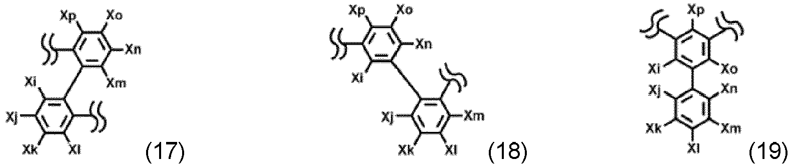 wherein
Xi to Xp, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3-to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino; or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur; and 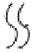 represents a bonding site to a mother nucleus.
Xi to Xp, each independently, may represent preferably, hydrogen, a halogen, a cyano, a (C1-C10)alkyl, a (C3-C20)cycloalkyl, a (C6-C12)aryl, a (C1-C6)alkyldi(C6-C12)arylsilyl, or a tri(C6-C12)arylsilyl; and more preferably, hydrogen, a cyano, a (C1-C6)alkyl, or a tri(C6-C12)arylsilyl.

In formula 2, Ma represents a substituted or unsubstituted monocyclic ring-type heteroaryl selected from the group consisting of a substituted or unsubstituted pyrrolyl, a substituted or unsubstituted imidazolyl, a substituted or unsubstituted pyrazolyl, a substituted or unsubstituted triazinyl, a substituted or unsubstituted tetrazinyl, a substituted or unsubstituted triazolyl, a substituted or unsubstituted tetrazolyl, a substituted or unsubstituted pyridyl, a substituted or unsubstituted pyrazinyl, a substituted or unsubstituted pyrimidinyl, and a substituted or unsubstituted pyridazinyl, or a substituted or unsubstituted fused ring-type heteroaryl selected from the group consisting of a substituted or unsubstituted benzimidazolyl, a substituted or unsubstituted isoindolyl, a substituted or unsubstituted indolyl, a substituted or unsubstituted indazolyl, a substituted or unsubstituted benzothiadiazolyl, a substituted or unsubstituted quinolyl, a substituted or unsubstituted isoquinolyl, a substituted or unsubstituted cinnolinyl, a substituted or unsubstituted quinazolinyl, a substituted or unsubstituted naphthyridinyl, and a substituted or unsubstituted quinoxalinyl. Preferably, Ma may represent a substituted or unsubstituted triazinyl, a substituted or unsubstituted pyrimidinyl, a substituted or unsubstituted pyridyl, a substituted or unsubstituted quinolyl, a substituted or unsubstituted isoquinolyl, a substituted or unsubstituted quinazolinyl, a substituted or unsubstituted naphthyridinyl, or a substituted or unsubstituted quinoxalinyl. The substituents for the substituted pyrrolyl, etc., of Ma may be a (C6-C18)aryl, a (C6-C12)aryl substituted with a cyano, a (C6-C12)aryl substituted with a (C1-C6)alkyl, a (C6-C12)aryl substituted with a tri(C6-C12)arylsilyl, a cyano, a (C1-C6)alkyl, a tri(C6-C12)arylsilyl, or a 6- to 15-membered heteroaryl; and specifically, phenyl, biphenyl, terphenyl, naphthyl, phenylnaphthyl, naphthylphenyl, phenanthrenyl, anthracenyl, dibenzothiophenyl, or dibenzofuranyl, unsubstituted or substituted with a cyano, a (C1-C6)alkyl, or triphenylsilyl.

In formula 2, La represents a single bond, or a substituted or unsubstituted (C6-C30)arylene; and preferably, a single bond, or a substituted or unsubstituted (C6-C12)arylene. Specifically, La may represent a single bond, or any one of formulae 7 to 19.

In formula 2, Xa, and Xc to Xh, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino. Xb represents a substituted or unsubstituted dibenzofurayl or a substituted or unsubstituted dibenzothiophenyl. Preferably, Xa, and Xc to Xh, each independently, may represent hydrogen, a cyano, a substituted or unsubstituted (C6-C15)aryl, a substituted or unsubstituted 10- to 20-membered heteroaryl, or a substituted or unsubstituted tri(C6-C10)arylsilyl, or may be linked to an adjacent substituent(s) to form a substituted or unsubstituted (C6-C20) , mono-or polycyclic, aromatic ring, whose carbon atom(s) may be replaced with at least one hetero atom selected from nitrogen, oxygen, and sulfur. More preferably, Xa, and Xc to Xh, each independently, may represent hydrogen, a cyano, a (C6-C15)aryl unsubstituted or substituted with a tri(C6-C10)arylsily, or a 10- to 20-membered heteroaryl unsubstituted or substituted with a (C6-C12)aryl, or may be linked to an adjacent substituent(s) to form a substituted or unsubstituted benzene, a substituted or unsubstituted indole, a substituted or unsubstituted benzindole, a substituted or unsubstituted indene, a substituted or unsubstituted benzofuran, or a substituted or unsubstituted benzothiophene.

Herein, "(C1-C30)alkyl" indicates a linear or branched alkyl having 1 to 30, preferably 1 to 20, and more preferably 1 to 10 carbon atoms, and includes methyl, ethyl, n-propyl, isopropyl, n-butyl, isobutyl, tert-butyl, etc. "(C2-C30) alkenyl" indicates a linear or branched alkenyl having 2 to 30, preferably 2 to 20, and more preferably 2 to 10 carbon atoms and includes vinyl, 1-propenyl, 2-propenyl, 1-butenyl, 2-butenyl, 3-butenyl, 2-methylbut-2-enyl, etc. "(C2-C30)alkynyl" indicates a linear or branched alkynyl having 2 to 30, preferably 2 to 20, and more preferably 2 to 10 carbon atoms and includes ethynyl, 1-propynyl, 2-propynyl, 1-butynyl, 2-butynyl, 3-butynyl, 1-methylpent-2-ynyl, etc. "(C3-C30)cycloalkyl" indicates a mono- or polycyclic hydrocarbon having 3 to 30, preferably 3 to 20, and more preferably 3 to 7 ring backbone carbon atoms and includes cyclopropyl, cyclobutyl, cyclopentyl, cyclohexyl, etc. "3-to 7-membered heterocycloalkyl" indicates a cycloalkyl having 3 to 7, preferably 5 to 7 ring backbone atoms including at least one hetero atom selected from B, N, O, S, Si, and P, preferably O, S, and N, and includes tetrahydrofuran, pyrrolidine, thiolan, tetrahydropyran, Furthermore, "(C6-C30)aryl(ene)" indicates a monocyclic or fused ring-based radical derived from an aromatic hydrocarbon and having 6 to 30, preferably 6 to 20, and more preferably 6 to 15 ring backbone carbon atoms, and includes phenyl, biphenyl, terphenyl, naphthyl, binaphthyl, phenylnaphthyl, naphthylphenyl, fluorenyl, phenylfluorenyl, benzofluorenyl, dibenzofluorenyl, phenanthrenyl, phenylphenanthrenyl, anthracenyl, indenyl, triphenylenyl, pyrenyl, tetracenyl, perylenyl, chrysenyl, naphthacenyl, fluoranthenyl, etc. "3- to 30-membered heteroaryl" indicates an aryl group having 3 to 30 ring backbone atoms including at least one, preferably 1 to 4, hetero atom selected from the group consisting of B, N, O, S, Si, and P; may be a monocyclic ring, or a fused ring condensed with at least one benzene ring; may be partially saturated; may be one formed by linking at least one heteroaryl or aryl group to a heteroaryl group via a single bond(s); and includes a monocyclic ring-type heteroaryl such as furyl, thiophenyl, pyrrolyl, imidazolyl, pyrazolyl, thiazolyl, thiadiazolyl, isothiazolyl, isoxazolyl, oxazolyl, oxadiazolyl, triazinyl, tetrazinyl, triazolyl, tetrazolyl, furazanyl, pyridyl, pyrazinyl, pyrimidinyl, pyridazinyl, etc., and a fused ring-type heteroaryl such as benzofuranyl, benzothiophenyl, isobenzofuranyl, dibenzofuranyl, dibenzothiophenyl, benzoimidazolyl, benzothiazolyl, benzoisothiazolyl, benzoisoxazolyl, benzoxazolyl, isoindolyl, indolyl, benzindolyl, indazolyl, benzothiadiazolyl, quinolyl, isoquinolyl, cinnolinyl, quinazolinyl, quinoxalinyl, carbazolyl, phenoxazinyl, phenanthridinyl, benzodioxolyl, etc. The "nitrogen-containing 5- to 30-membered heteroaryl" indicates a heteroaryl group having 5 to 30, preferably 5 to 20, and more preferably 5 to 15 ring backbone atoms including at least one, preferably 1 to 4, nitrogen as the hetero atom; may be a monocyclic ring, or a fused ring condensed with at least one benzene ring; may be partially saturated; may be one formed by linking at least one heteroaryl or aryl group to a heteroaryl group via a single bond(s); and includes a monocyclic ring-type heteroaryl such as pyrrolyl, imidazolyl, pyrazolyl, triazinyl, tetrazinyl, triazolyl, tetrazolyl, pyridyl, pyrazinyl, pyrimidinyl, pyridazinyl, etc., and a fused ring-type heteroaryl such as benzoimidazolyl, isoindolyl, indolyl, indazolyl, benzothiadiazolyl, quinolyl, isoquinolyl, cinnolinyl, quinazolinyl, quinoxalinyl, carbazolyl, phenanthridinyl, etc. Furthermore, "halogen" includes F, Cl, Br, and I.

Herein, "substituted" in the expression, "substituted or unsubstituted," means that a hydrogen atom in a certain functional group is replaced with another atom or group, i.e. a substituent. In the present disclosure, the substituents of the substituted alkyl, the substituted alkenyl, the substituted alkynyl, the substituted cycloalkyl, the substituted aryl(ene), the substituted heteroaryl, the substituted trialkylsilyl, the substituted arylsilyl, the substituted dialkylarylsilyl, the substituted mono- or di-arylamino, and the substituted nitrogen-containing heteroaryl of A₁, A₂, L₁, X₁ to X₁₆, Ma, La and Xa to Xh in formulae 1 and 2, each independently, are at least one selected from the group consisting of deuterium, a halogen, a cyano, a carboxy, a nitro, a hydroxy, a (C1-C30)alkyl, a halo(C1-C30)alkyl, a (C2-C30)alkenyl, a (C2-C30)alkynyl, a (C1-C30)alkoxy, a (C1-C30)alkylthio, a (C3-C30)cycloalkyl, a (C3-C30)cycloalkenyl, a 3- to 7-membered heterocycloalkyl, a (C6-C30)aryloxy, a (C6-C30)arylthio, a 3- to 30-membered heteroaryl unsubstituted or substituted with a (C6-C30)aryl, a (C6-C30)aryl unsubstituted or substituted with a cyano, a 3- to 30-membered heteroaryl, or a tri(C6-C30)arylsilyl, a tri(C1-C30)alkylsilyl, a tri(C6-C30)arylsilyl, a di(C1-C30)alkyl(C6-C30)arylsilyl, a (C1-C30)alkyldi(C6-C30)arylsilyl, an amino, a mono- or di-(C1-C30)alkylamino, a mono- or di-(C6-C30)arylamino, a (C1-C30)alkyl(C6-C30)arylamino, a (C1-C30)alkylcarbonyl, a (C1-C30)alkoxycarbonyl, a (C6-C30)arylcarbonyl, a di(C6-C30)arylboronyl, a di(C1-C30)alkylboronyl, a (C1-C30)alkyl(C6-C30)arylboronyl, a (C6-C30)aryl(C1-C30)alkyl, and a (C1-C30)alkyl(C6-C30)aryl; and preferably a cyano, a (C1-C6)alkyl, a 5- to 15-membered heteroaryl, a (C6-C18)aryl unsubstituted or substituted with a cyano or a tri(C6-C12)arylsilyl, a tri(C6-C12)arylsilyl, and a (C1-C6)alkyl(C6-C12)aryl.

In formula 1, triarylsilyl of X₁ to X₁₆ in formula 1 is preferably triphenylsilyl.

The first host compound represented by formula 1 includes the following, but is not limited thereto.

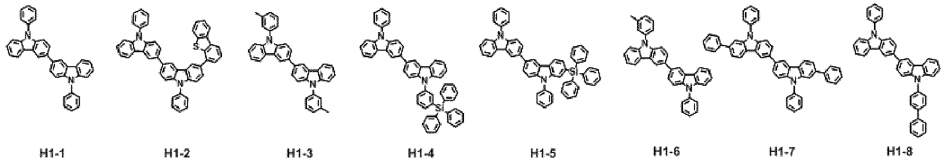

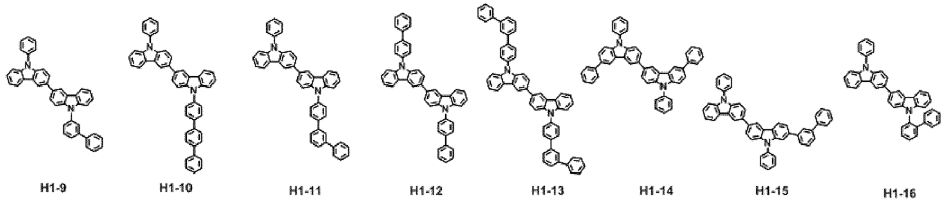

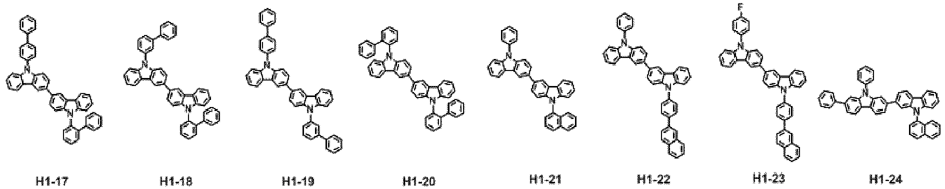

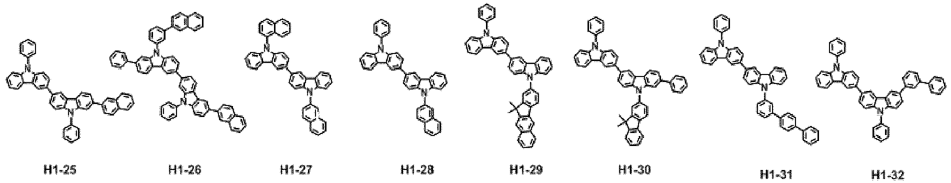

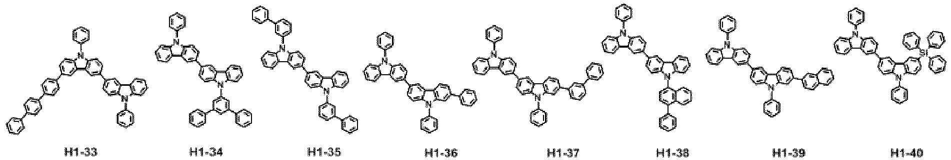

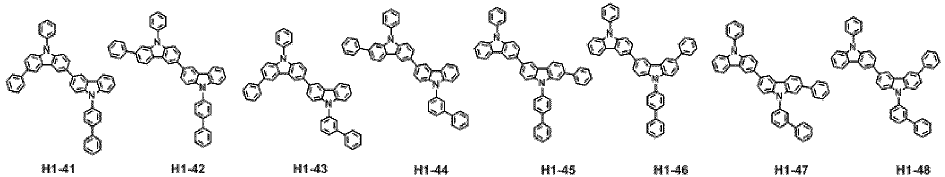

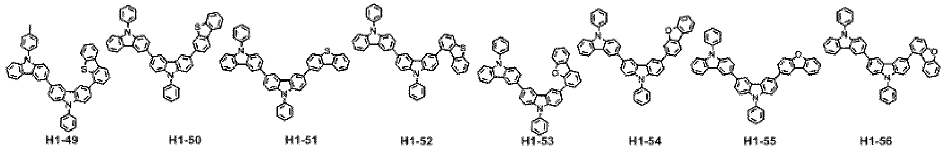

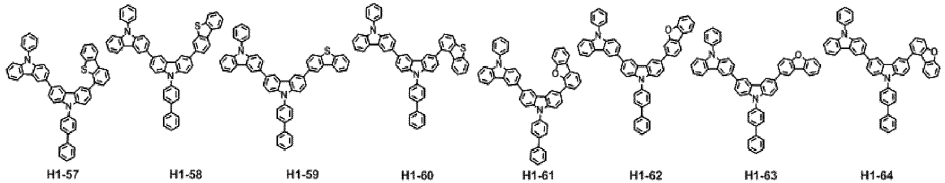

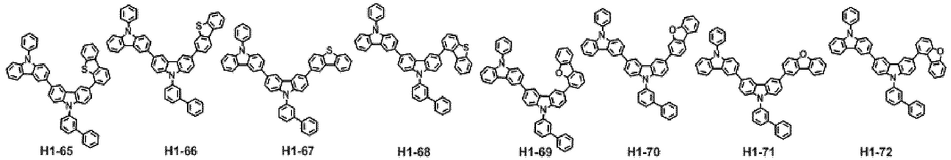

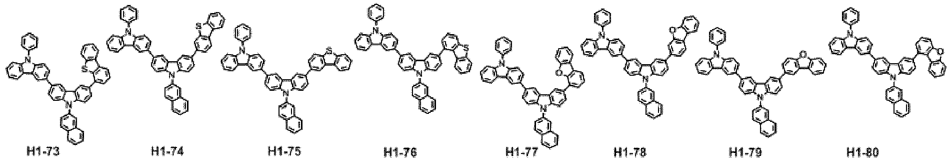

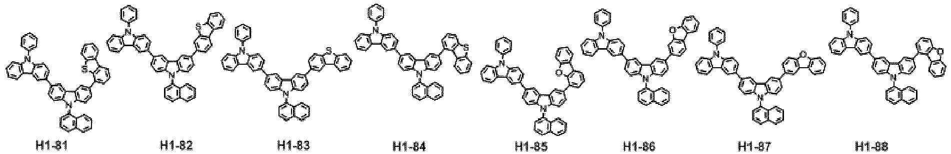

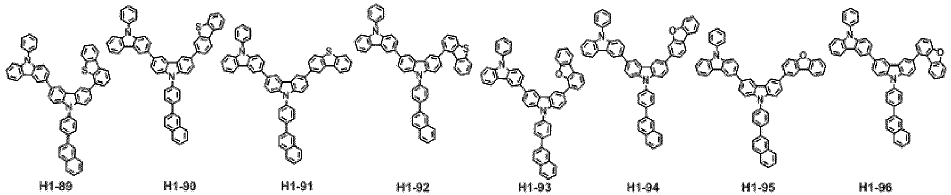

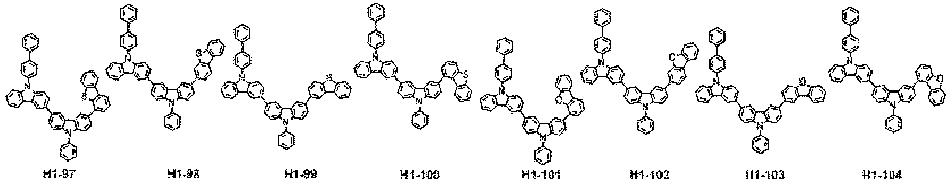

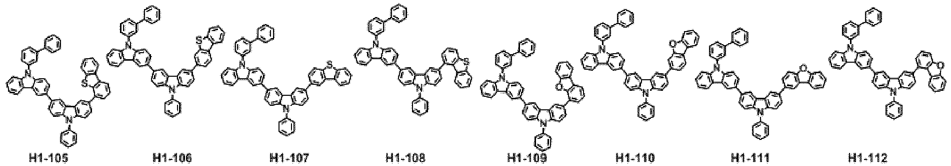

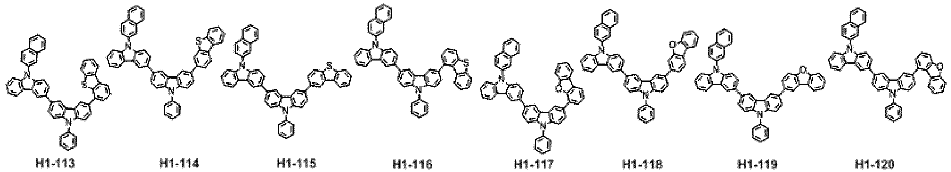

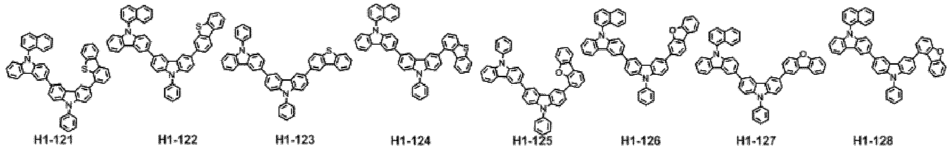

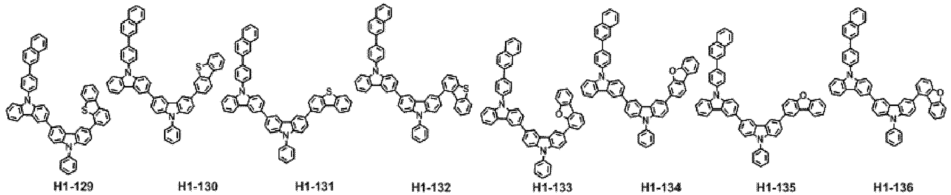

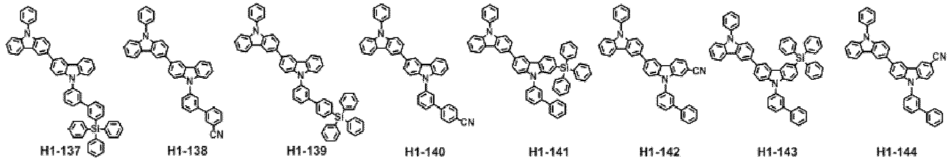

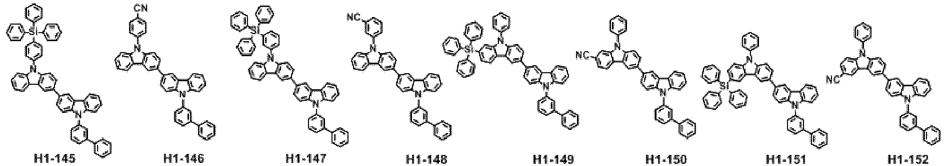

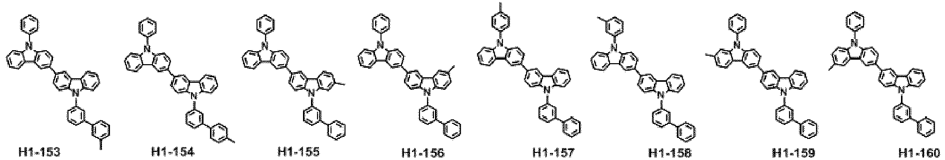

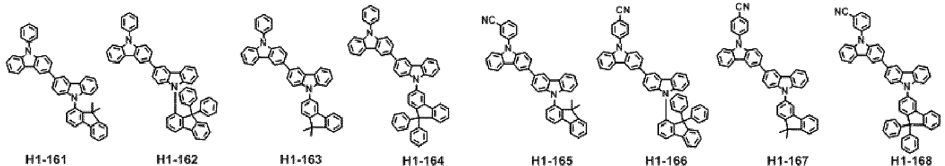

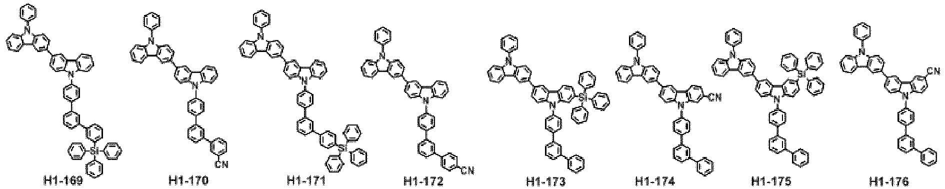

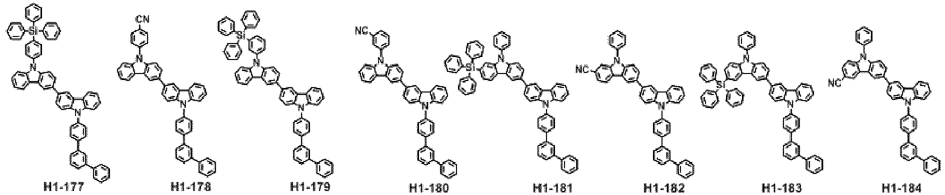

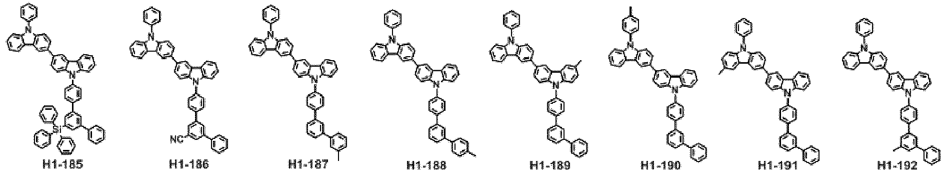

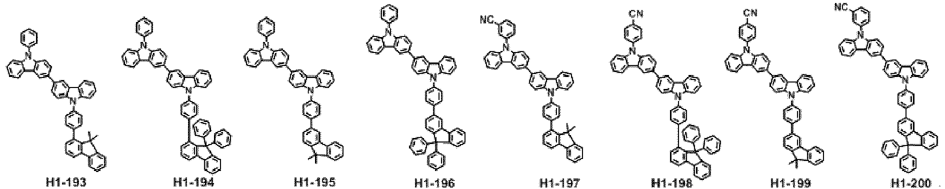

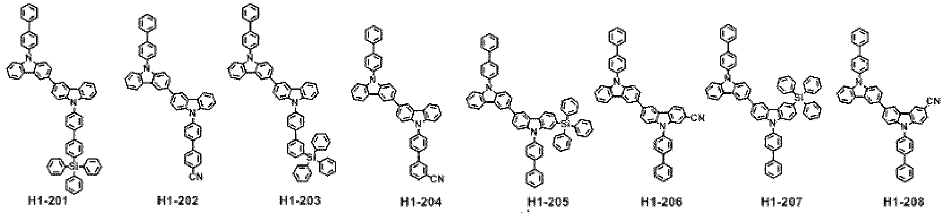

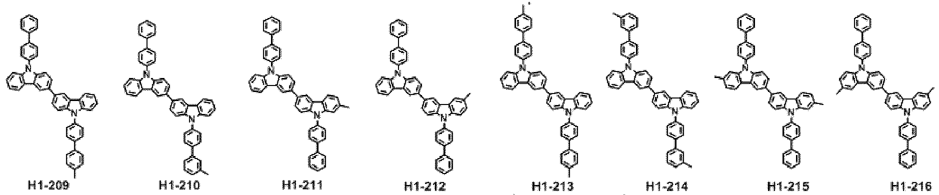

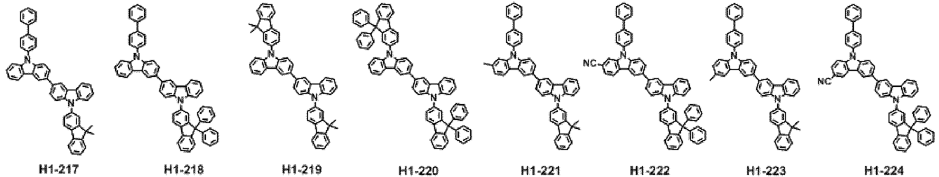

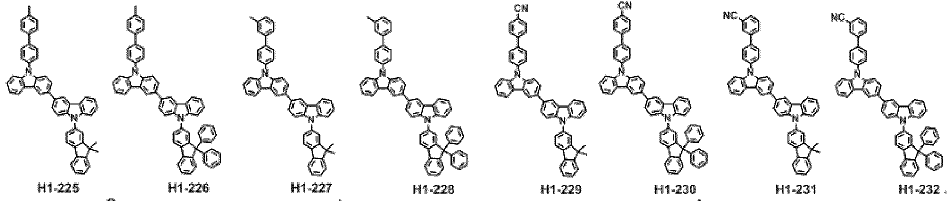

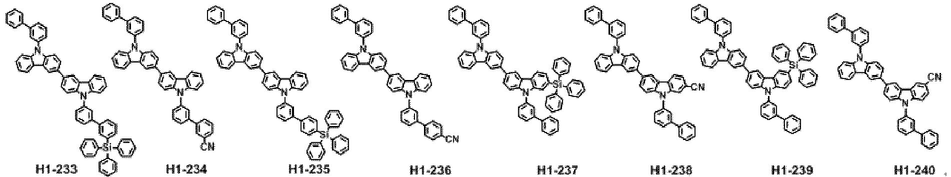

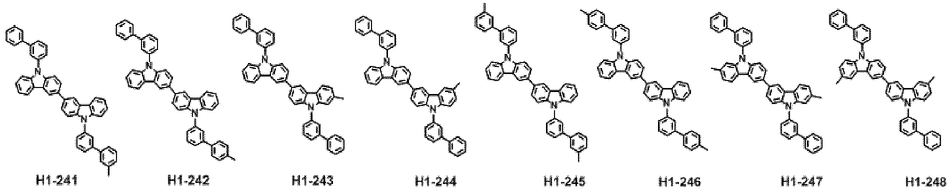

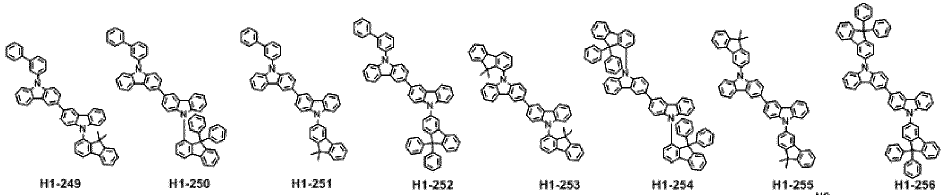

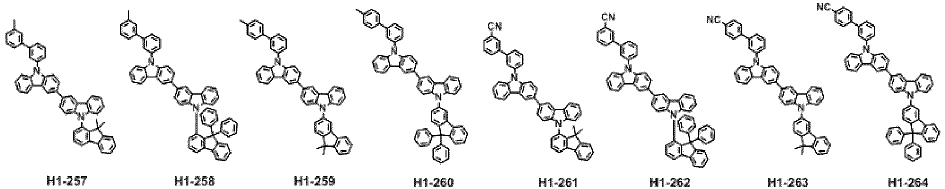

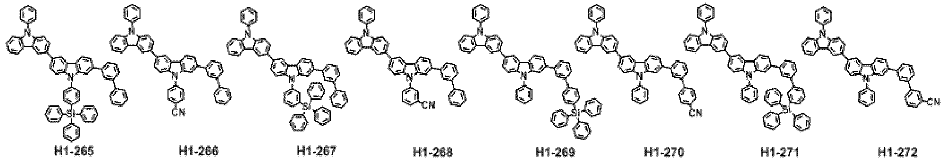

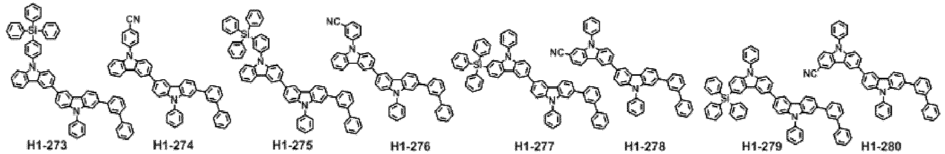

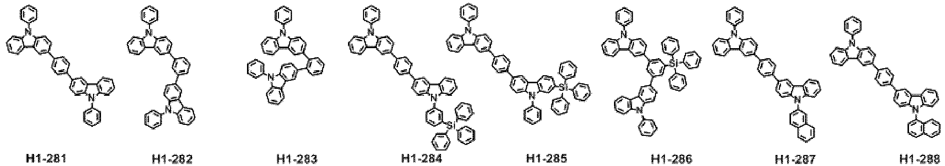

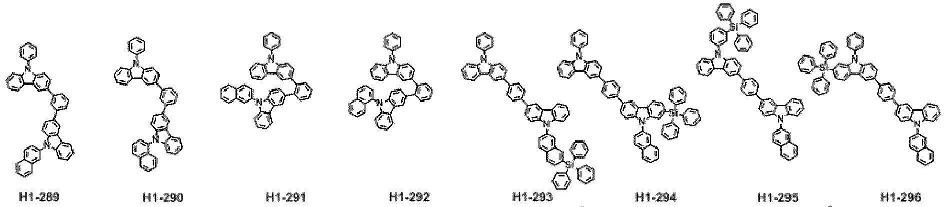

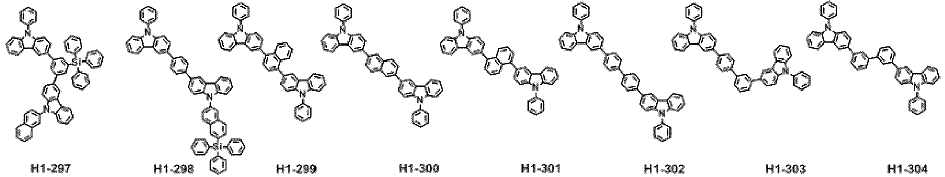

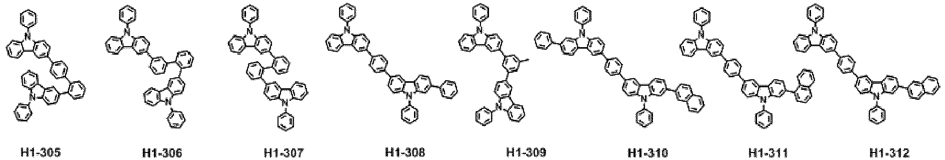

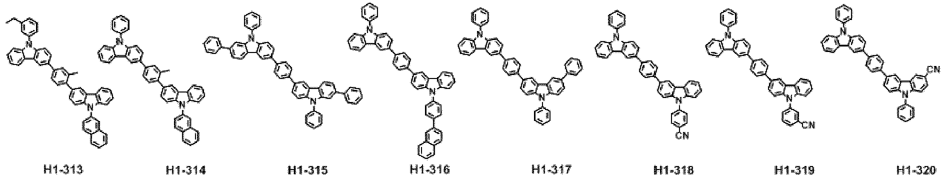

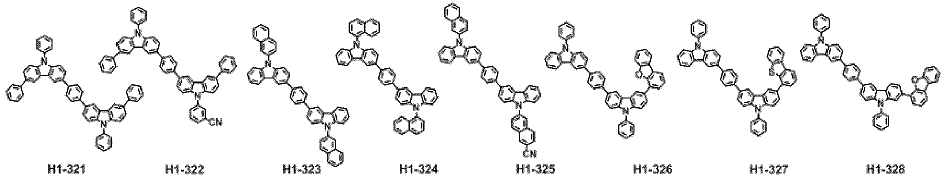

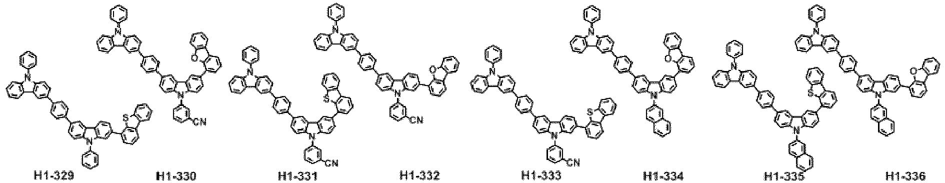

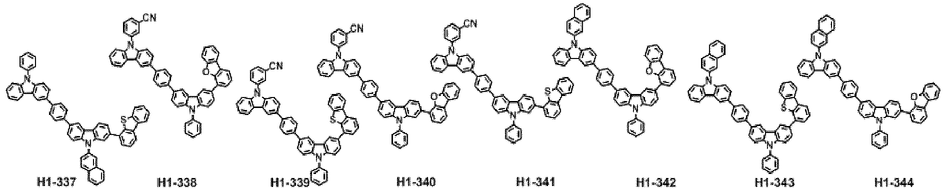

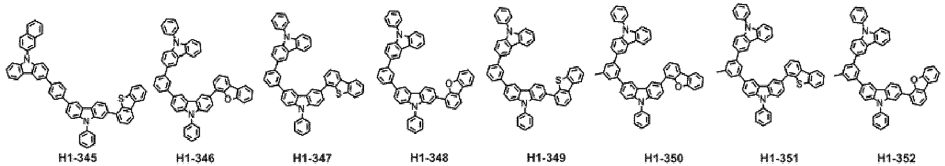

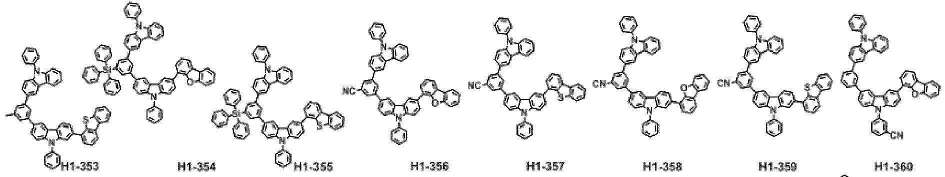

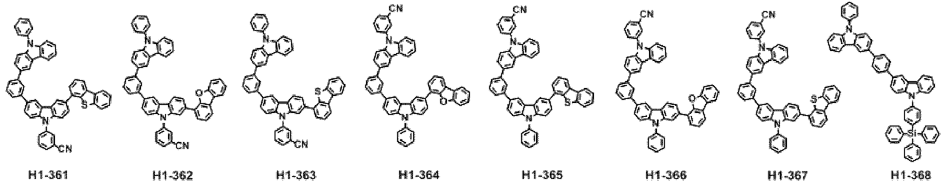

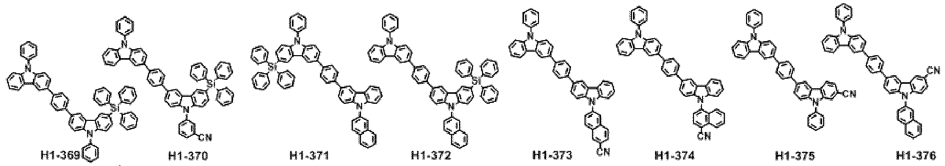

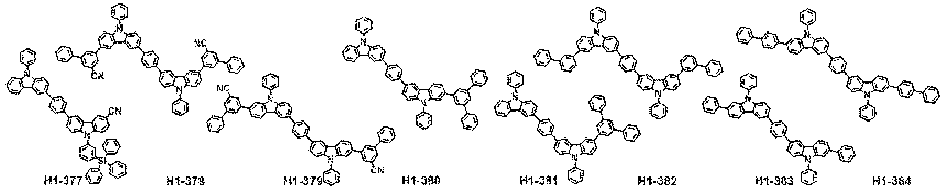

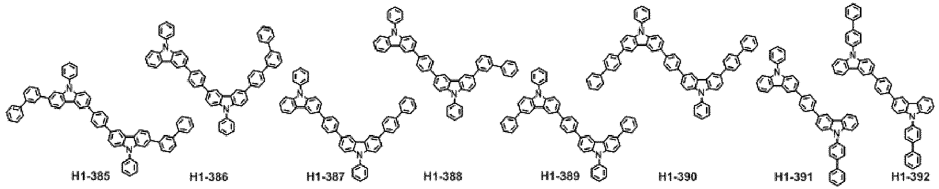

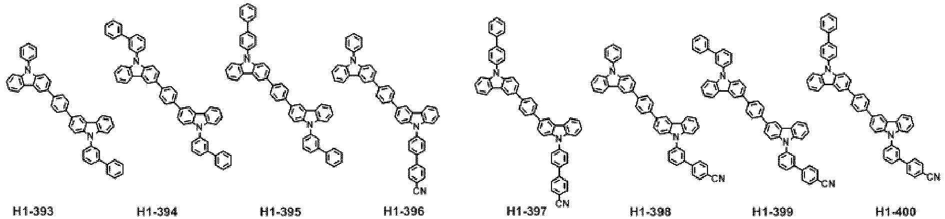

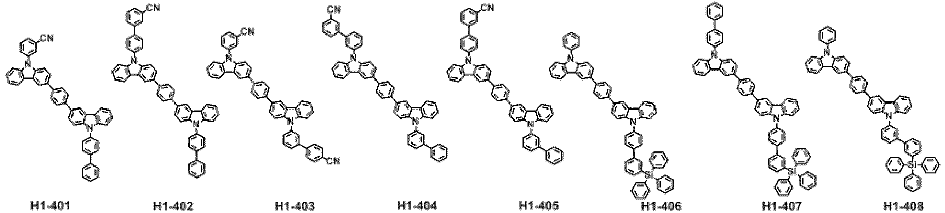

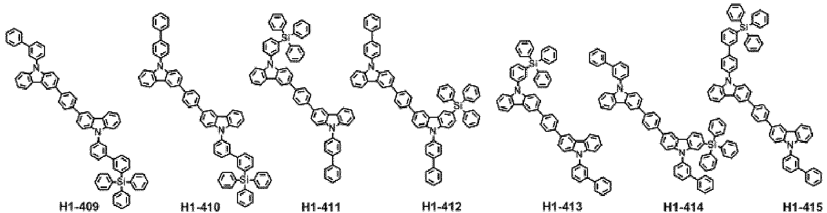

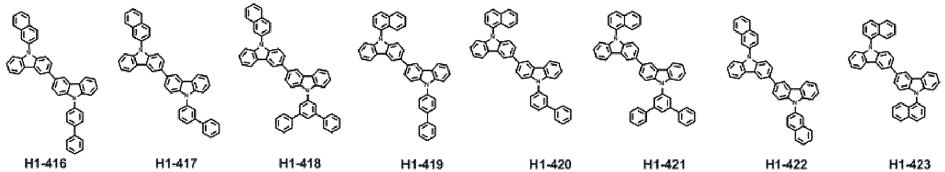

The second host compound represented by formula 2 includes the following, but is not limited thereto:

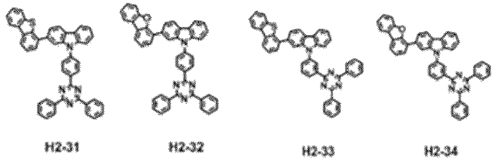

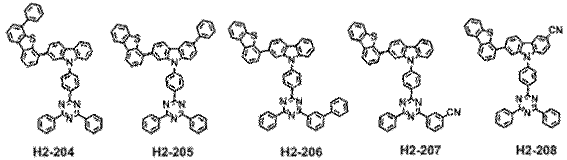

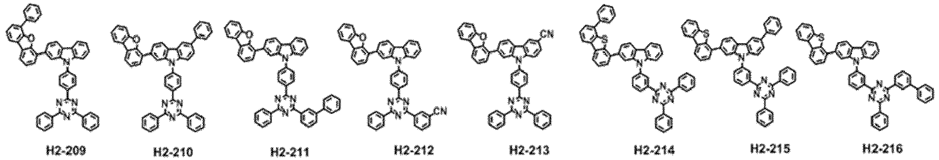

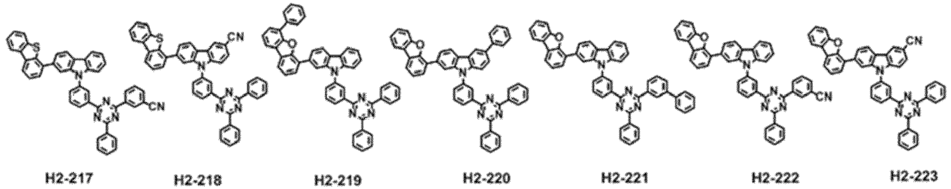

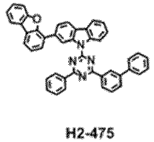

The hole transport compound of formula 1 includes compounds H1-1 to H1-423, but is not limited thereto.

The organic electroluminescent device of the present disclosure comprises an anode, a cathode, and an organic layer between the anode and the cathode, wherein the organic layer comprises one or more light-emitting layers and one or more hole transport layers; at least one of the one or more light-emitting layers comprises one or more dopant compounds and two or more host compounds; a first host compound of the host compounds is represented by formula 1; a second host compound is represented by formula 2; and at least one of the one or more hole transport layers comprises the compound represented by formula 1. The first host compound of formula 1 and the compound for the hole transport layer of formula 1 may be the same or different.

The light-emitting layer indicates a layer from which light is emitted. It is preferable that a doping amount of the dopant compound is less than 20 wt% based on the total amount of the host compound and the dopant compound in a light-emitting layer. In the organic electroluminescent device of the present disclosure, the weight ratio in the light-emitting layer between the first host material and the second host material may be in the range of 1:99 to 99:1, and specifically 30:70 to 70:30.

In addition to the light-emitting layer and the hole transport layer, the organic layer may comprise at least one layer selected from a hole injection layer, an electron transport layer, an electron injection layer, an electron buffering layer, an interlayer, a hole blocking layer, and an electron blocking layer.

The dopant to be comprised in the organic electroluminescent device of the present disclosure is preferably at least one phosphorescent dopant. The phosphorescent dopant material for the organic electroluminescent device of the present disclosure is not limited, but may be preferably selected from metallated complex compounds of iridium (Ir), osmium (Os), copper (Cu) or platinum (Pt), more preferably selected from ortho-metallated complex compounds of iridium (Ir), osmium (Os), copper (Cu) or platinum (Pt), and even more preferably ortho-metallated iridium complex compounds.

Preferably, the phosphorescent dopant may be selected from the group consisting of compounds represented by the following formulae 101 to 103. 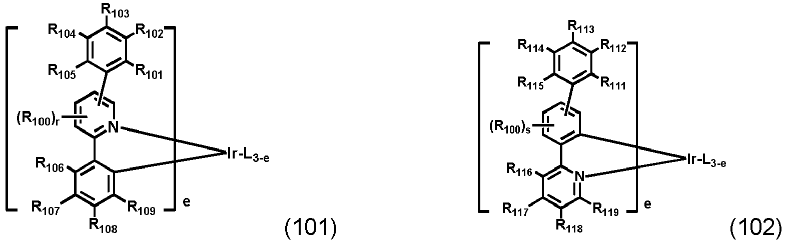 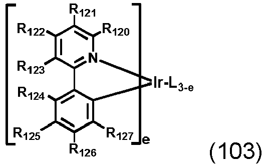
wherein L is selected from the following structures: 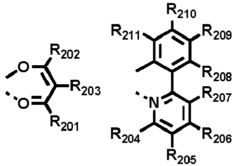
R₁₀₀ represents hydrogen, a substituted or unsubstituted (C1-C30)alkyl, or a substituted or unsubstituted (C3-C30)cycloalkyl;
R₁₀₁ to R₁₀₉ and R₁₁₁ to R₁₂₃, each independently, represent hydrogen, deuterium, a halogen, a (C1-C30)alkyl unsubstituted or substituted with a halogen, a cyano, a substituted or unsubstituted (C1-C30)alkoxy, or a substituted or unsubstituted (C3-C30)cycloalkyl; R₁₀₆ to R₁₀₉ may be linked to an adjacent substituent(s) to form a substituted or unsubstituted 3- to 30-membered, mono- or polycyclic, alicyclic or aromatic ring (for example, a substituted or unsubstituted fluorene, a substituted or unsubstituted dibenzothiophene, or a substituted or unsubstituted dibenzofuran); R₁₂₀ to R₁₂₃, each independently, may be linked to an adjacent substituent(s) to form a substituted or unsubstituted 3- to 30-membered, mono- or polycyclic, alicyclic or aromatic ring (for example, a substituted or unsubstituted quinoline);
R₁₂₄ to R₁₂₇, each independently, represent hydrogen, deuterium, a halogen, a substituted or unsubstituted (C1-C30)alkyl, or a substituted or unsubstituted (C6-C30)aryl; where R₁₂₄, R₁₂₅, R₁₂₆, or R₁₂₇ is aryl, it may be linked to an adjacent substituent(s) to form a substituted or unsubstituted 3- to 30-membered, mono- or polycyclic, alicyclic or aromatic ring (for example, a substituted or unsubstituted fluorene, a substituted or unsubstituted dibenzothiophene, or a substituted or unsubstituted dibenzofuran);
R₂₀₁ to R₂₁₁, each independently, represent hydrogen, deuterium, a halogen, a (C1-C30)alkyl unsubstituted or substituted with a halogen, a substituted or unsubstituted (C3-C30)cycloalkyl, or a substituted or unsubstituted (C6-C30)aryl; R₂₀₈ to R₂₁₁, each independently, may be linked to an adjacent substituent(s) to form a substituted or unsubstituted 3- to 30-membered, mono- or polycyclic, alicyclic or aromatic ring (for example, a substituted or unsubstituted fluorene, a substituted or unsubstituted dibenzothiophene, or a substituted or unsubstituted dibenzofuran);
r and s, each independently, represent an integer of 1 to 3; when r or s is an integer of 2 or more, each of R₁₀₀ may be the same or different; and e represents an integer of 1 to 3.

Specifically, the phosphorescent dopant material includes the following:

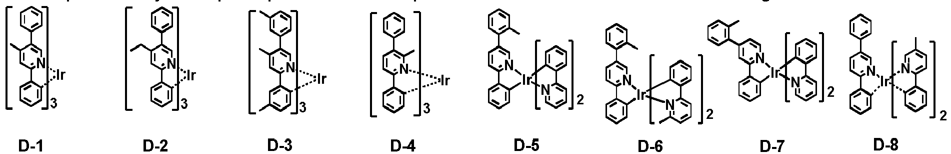

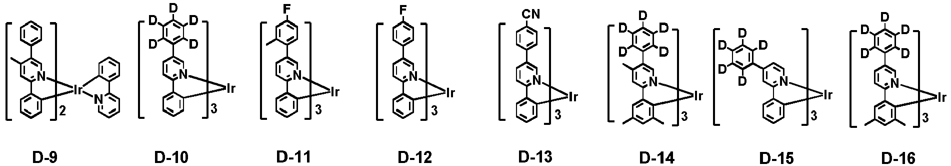

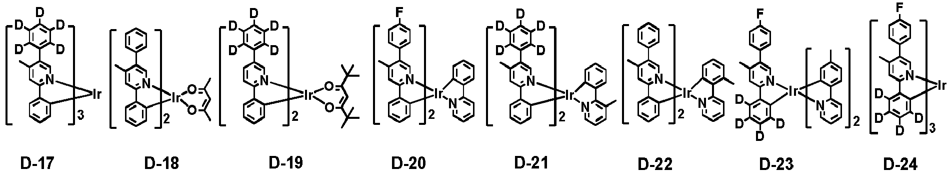

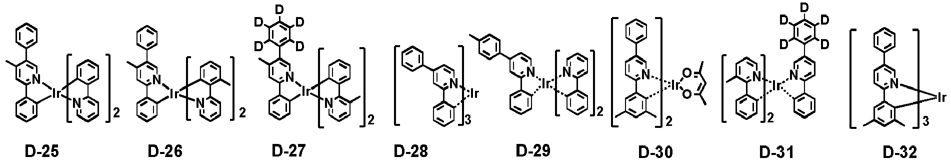

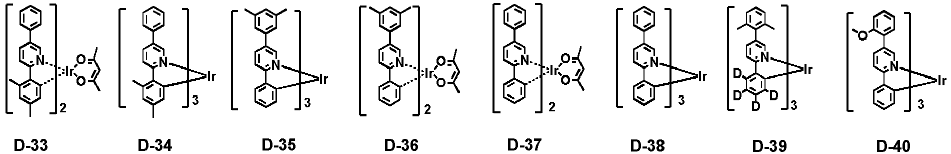

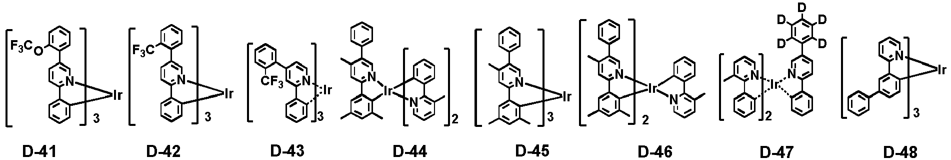

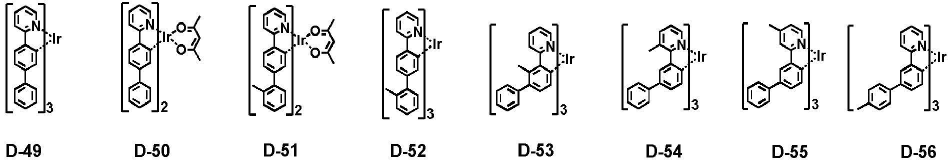

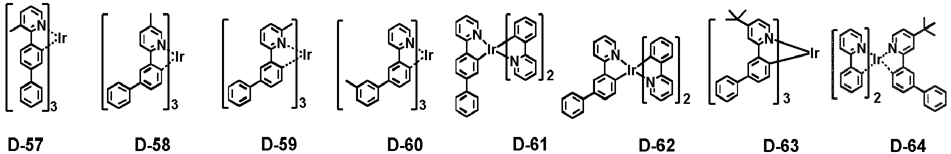

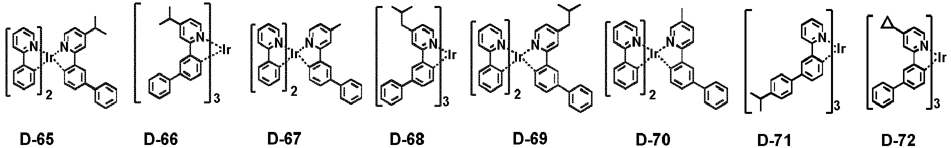

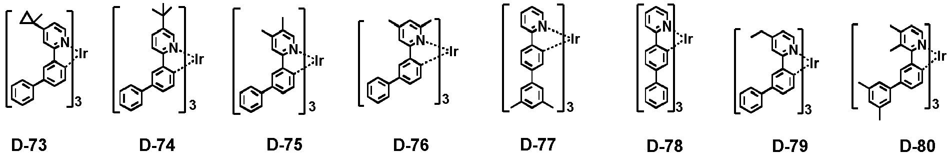

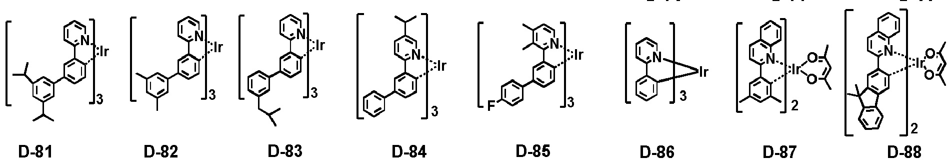

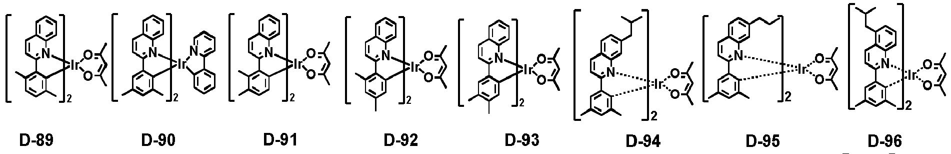

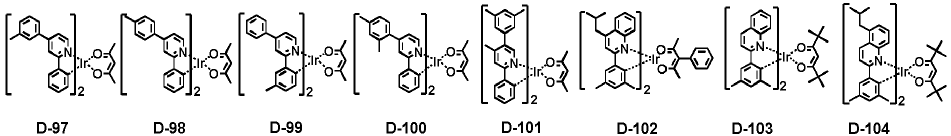

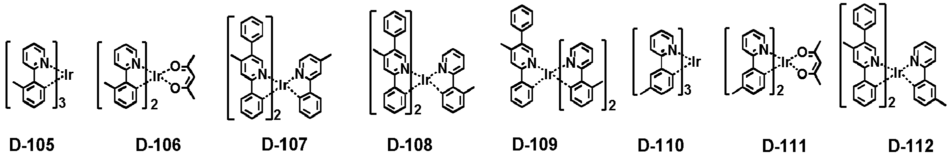

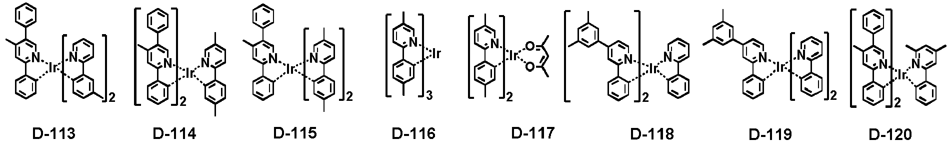

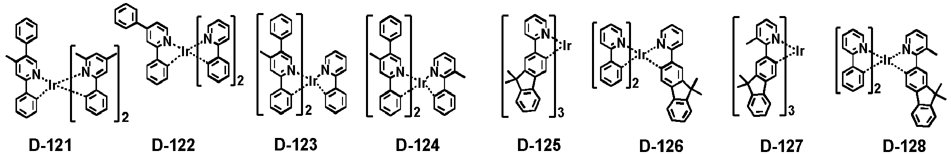

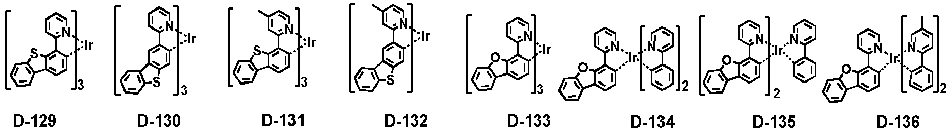

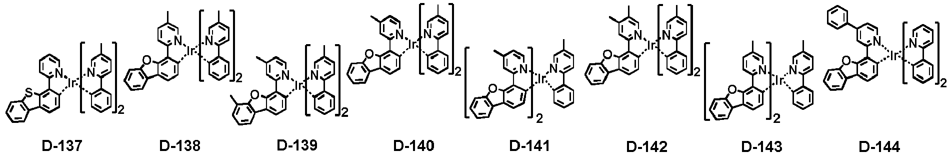

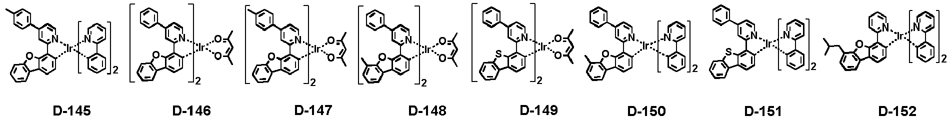

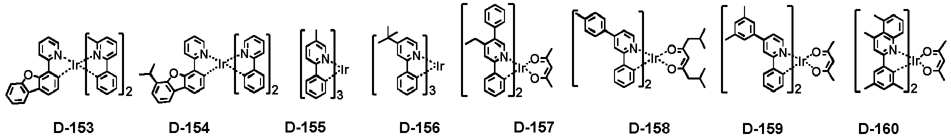

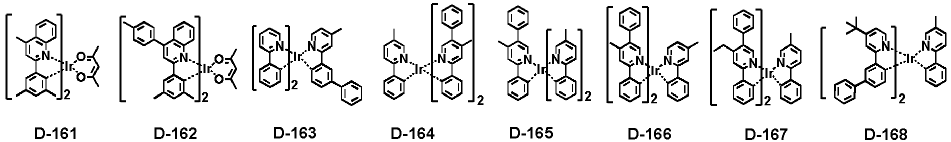

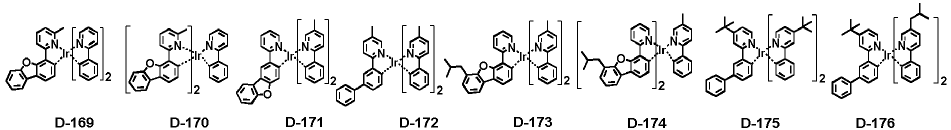

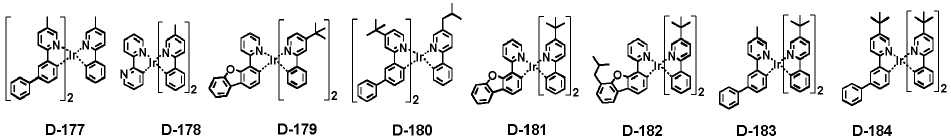

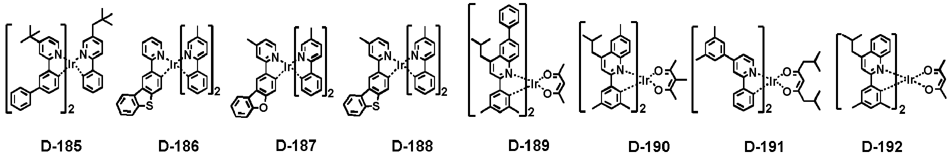

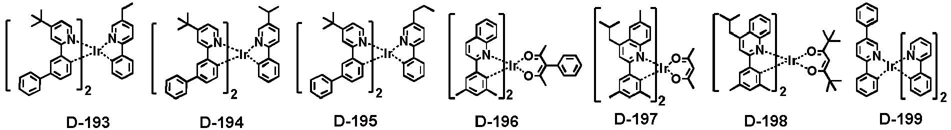

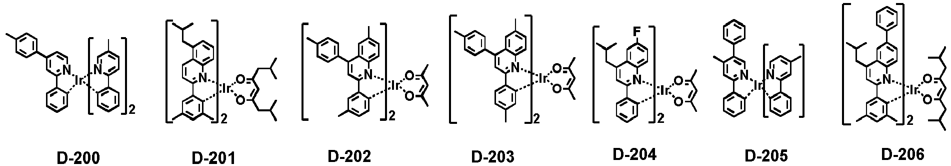

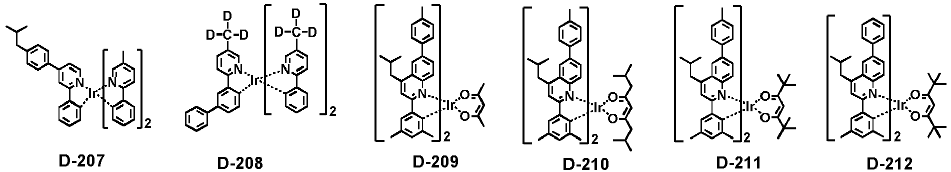

In the organic electroluminescent device of the present disclosure, the organic layer may further comprise at least one compound selected from the group consisting of arylamine-based compounds and styrylarylamine-based compounds.

In the organic electroluminescent device of the present disclosure, the organic layer may further comprise at least one metal selected from the group consisting of metals of Group 1, metals of Group 2, transition metals of the 4^{th} period, transition metals of the 5^{th} period, lanthanides and organic metals of the d-transition elements of the Periodic Table, or at least one complex compound comprising the metal.

In the organic electroluminescent device of the present disclosure, preferably, at least one layer (hereinafter, "a surface layer") may be placed on an inner surface(s) of one or both electrode(s), selected from a chalcogenide layer, a metal halide layer and a metal oxide layer. Specifically, a chalcogenide (includes oxides) layer of silicon or aluminum is preferably placed on an anode surface of an electroluminescent medium layer, and a metal halide layer or a metal oxide layer is preferably placed on a cathode surface of an electroluminescent medium layer. Such a surface layer provides operation stability for the organic electroluminescent device. Preferably, the chalcogenide includes SiOx (1≤X≤2), AlOx (1≤X≤1.5), SiON, SiAlON, etc.; the metal halide includes LiF, MgF₂, CaF₂, a rare earth metal fluoride, etc.; and the metal oxide includes Cs₂O, Li₂O, MgO, SrO, BaO, CaO, etc.

In addition to the hole transport layer, a hole injection layer, an electron blocking layer, or a combination thereof may be disposed between the anode and the light-emitting layer. The hole injection layer may be composed of two or more layers in order to lower an energy barrier for injecting holes from the anode to a hole transport layer or an electron blocking layer (or a voltage for injecting a hole). Each of the layers may comprise two or more compounds. The electron blocking layer may be composed of two or more layers.

An electron buffering layer, a hole blocking layer, an electron transport layer, an electron injection layer, or a combination thereof may be disposed between the light-emitting layer and the cathode. The electron buffering layer may be composed of two or more layers in order to control the electron injection and improve characteristics of interface between the light-emitting layer and the electron injection layer. Each of the layers may comprise two or more compounds. The hole blocking layer or electron transport layer may be composed of two or more layers, and each of the layers may comprise two or more compounds.

In the organic electroluminescent device of the present disclosure, a mixed region of an electron transport compound and a reductive dopant, or a mixed region of a hole transport compound and an oxidative dopant may be placed on at least one surface of a pair of electrodes. In this case, the electron transport compound is reduced to an anion, and thus it becomes easier to inject and transport electrons from the mixed region to an electroluminescent medium. Furthermore, the hole transport compound is oxidized to a cation, and thus it becomes easier to inject and transport holes from the mixed region to the electroluminescent medium. Preferably, the oxidative dopant includes various Lewis acids and acceptor compounds, and the reductive dopant includes alkali metals, alkali metal compounds, alkaline earth metals, rare-earth metals, and mixtures thereof. A reductive dopant layer may be employed as a charge generating layer to prepare an electroluminescent device having two or more light-emitting layers and emitting white light.

In order to form each layer of the organic electroluminescent device of the present disclosure, dry film-forming methods such as vacuum evaporation, sputtering, plasma and ion plating methods, or wet film-forming methods such as inkjet printing, nozzle printing, slot coating, spin coating, dip coating, and flow coating methods can be used. Where a layer is formed with the first host compound and the second host compound of the present disclosure, they may be co-evaporated or mixture-evaporated.

When using a wet film-forming method, a thin film can be formed by dissolving or diffusing materials forming each layer into any suitable solvent such as ethanol, chloroform, tetrahydrofuran, dioxane, etc. The solvent can be any solvent where the materials forming each layer can be dissolved or diffused, and where there are no problems in film-formation capability.

In the organic electroluminescent device of the present disclosure, two or more host compounds for a light-emitting layer may be co-evaporated or mixture-evaporated. Herein, a co-evaporation indicates a process for two or more materials to be deposited as a mixture, by introducing each of the two or more materials into respective crucible cells, and applying electric current to the cells for each of the materials to be evaporated. Herein, a mixture-evaporation indicates a process for two or more materials to be deposited as a mixture, by mixing the two or more materials in one crucible cell before the deposition, and applying electric current to the cell for the mixture to be evaporated.

The organic electroluminescent device of the present disclosure can be used for the manufacture of a display system or a lighting system.

Hereinafter, the preparation method of the device comprising the host compounds and the hole transport compound of the present disclosure, and its luminescent properties will be explained in detail with reference to the following examples.

### [Device Examples 1-1 to 1-3] OLED produced by an evaporation of a hole transport compound of the present disclosure, and a co-evaporation of a first host compound and a second host compound of the present disclosure

An organic electroluminescent device (OLED) was produced using the light-emitting material of the present disclosure as follows. A transparent electrode indium tin oxide (ITO) thin film (10 Ω/sq) on a glass substrate for OLED (Geomatec) was subjected to an ultrasonic washing with acetone, ethanol, and distilled water sequentially, and was then stored in isopropanol. The ITO substrate was then mounted on a substrate holder of a vacuum vapor depositing apparatus. N⁴,N⁴'-diphenyl-N⁴,N⁴'-bis(9-phenyl-9H-carbazol-3-yl)-[1,1'-biphenyl]-4,4'-diamine (compound **HI-1**) was introduced into a cell of the vacuum vapor depositing apparatus, and then the pressure in the chamber of the apparatus was controlled to 10⁻⁶ torr. Thereafter, an electric current was applied to the cell to evaporate **HI-1**, thereby forming a first hole injection layer having a thickness of 80 nm on the ITO substrate. Dipyrazino[2,3-f:2',3'-h]quinoxalin-2,3,6,7,10,11-hexacarbonitrile (compound **HI-2**) was then introduced into another cell of the vacuum vapor depositing apparatus, and evaporated by applying electric current to the cell, thereby forming a second hole injection layer having a thickness of 3 nm on the first hole injection layer. N-([1,1'-biphenyl]-4-yl)-9,9-dimethyl-N-(4-(9-phenyl-9H-carbazol-3-yl)phenyl)-9H-fluoren-2-amine (compound **HT-1**) was introduced into one cell of the vacuum vapor depositing apparatus, and evaporated by applying electric current to the cell, thereby forming a first hole transport layer having a thickness of 10 nm on the second hole injection layer. A compound for a second hole transport layer shown in Table 1 below was then introduced into another cell of the vacuum vapor depositing apparatus, and evaporated by applying electric current to the cell, thereby forming a second hole transport layer having a thickness of 30 nm on the first hole transport layer. As a host material, **H1-34** and **H2-31** were introduced into two cells of the vacuum vapor depositing apparatus, respectively. **D-25** was introduced into another cell as a dopant. The two host compounds were evaporated at the same rate of 1:1, while the dopant was evaporated at a different rate from the host compounds, so that the dopant was deposited in a doping amount of 15 wt% based on the total amount of the host and dopant to form a light-emitting layer having a thickness of 40 nm on the hole transport layer. 2,4-bis(9,9-dimethyl-9H-fluoren-2-yl)-6-(naphthalen-2-yl)-1,3,5-triazine (compound **ET-1**) and lithium quinolate (compound **EI-1**) were introduced into two cells of the vacuum vapor depositing apparatus, respectively, and evaporated at the same rate of 4:6, thereby forming an electron transport layer having a thickness of 35 nm on the light-emitting layer. After depositing lithium quinolate (compound **EI-1**) as an electron injection layer having a thickness of 2 nm on the electron transport layer, an Al cathode having a thickness of 80 nm was then deposited by another vacuum vapor deposition apparatus on the electron injection layer.

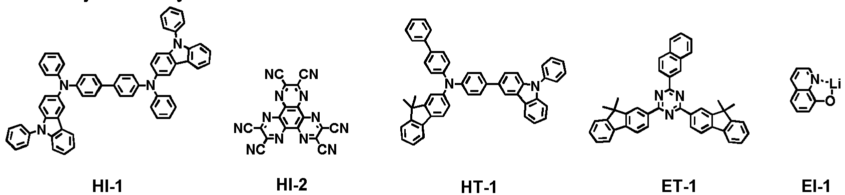

### [Comparative Example 1-1] OLED produced by an evaporation of HTL-A as a compound for a second hole transport layer

OLEDs were produced in the same manner as in Device Examples 1-1 to 1-3, except that HTL-A shown below was used as a compound for a second hole transport layer.

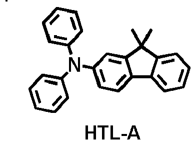

A driving voltage at 1,000 nit, luminous efficiency, CIE color coordinate, and time taken to be reduced from 100% to 95% of the luminance at 15,000 nit and a constant current (T95 lifespan) of OLEDs were measured. The characteristics of the organic electroluminescent devices produced in device examples 1-1 to 1-3 and comparative example 1-1 are shown in Table 1 below.

**[Table 1]**

| Device Example No. | The second hole transport layer | Voltage (V) | Efficiency (cd/A) | Color coordinate (x, y) | T95 Lifespan [hr] |
|---|---|---|---|---|---|
| 1-1 | H1-287 | 3.4 | 57.1 | 0.300, 0.657 | 40 |
| 1-2 | H1-1 | 3.3 | 58.3 | 0.297, 0.657 | 40 |
| 1-3 | H1-28 | 3.3 | 58.0 | 0.298, 0.658 | 47 |
| Comparative Example 1-1 | HTL-A | 3.5 | 51.6 | 0.301, 0.660 | 6 |

### [Device Examples 2-1 to 2-5] OLED produced by an evaporation of a hole transport compound of the present disclosure, and a co-evaporation of a first host compound and a second host compound of the present disclosure.

The device examples 2-1 to 2-5 are not according to the claimed invention.

OLED was produced using the light-emitting material of the present disclosure as follows. A transparent electrode indium tin oxide (ITO) thin film (10 Ω/sq) on a glass substrate for an organic electroluminescent device (OLED) (Geomatec) was subjected to an ultrasonic washing with acetone, ethanol, and distilled water sequentially, and was then stored in isopropanol. The ITO substrate was then mounted on a substrate holder of a vacuum vapor depositing apparatus. Dipyrazino[2,3-f:2',3'-h]quinoxalin-2,3,6,7,10,11-hexacarbonitrile (compound HI-1) was introduced into a cell of the vacuum vapor depositing apparatus, and then the pressure in the chamber of the apparatus was controlled to 10⁻⁶ torr. Thereafter, an electric current was applied to the cell to evaporate **HI-1**, thereby forming a first hole injection layer having a thickness of 5 nm on the ITO substrate. N,N'-bis(naphthalen-1-yl)-N,N'-bis(phenyl)-benzidine (compound **HI-2**) was then introduced into another cell of the vacuum vapor depositing apparatus, and evaporated by applying electric current to the cell, thereby forming a second hole injection layer having a thickness of 95 nm on the first hole injection layer. A compound for a first hole transport layer shown in Table 2 below was introduced into one cell of the vacuum vapor depositing apparatus, and evaporated by applying electric current to the cell, thereby forming a first hole transport layer having a thickness of 20 nm on the second hole injection layer. As a host material, **H1-281** and **H2-125** were introduced into two cells of the vacuum vapor depositing apparatus, respectively. **D-122** was introduced into another cell as a dopant. The two host compounds were evaporated while the dopant was evaporated at a different rate from the host compounds, so that the dopant was deposited in a doping amount of 12 wt% based on the total amount of the host and dopant to form a light-emitting layer having a thickness of 30 nm on the hole transport layer. 2,4,6-tris(9,9-dimethyl-9H-fluoren-2-yl)-1,3,5-triazine (compound **ET-1**) was introduced into a cell of the vacuum vapor depositing apparatus, and evaporated to form an electron transport layer having a thickness of 35 nm on the light-emitting layer. After depositing lithium quinolate (compound **EI-1**) as an electron injection layer having a thickness of 2 nm on the electron transport layer, an Al cathode having a thickness of 80 nm was then deposited by another vacuum vapor deposition apparatus on the electron injection layer.

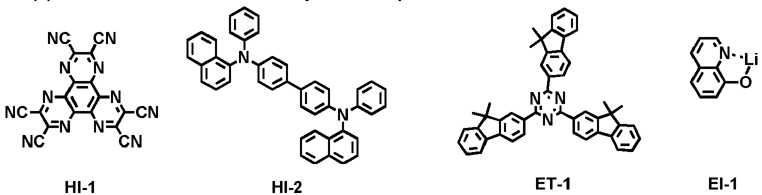

### [Device Examples 2-6 to 2-10] OLED produced by an evaporation of a hole transport compound of the present disclosure, and a co-evaporation of a first host compound and a second host compound of the present disclosure.

The device examples 2-6 to 2-10 are not according to the claimed invention.

OLEDs were produced in the same manner as in Device Examples 2-1 to 2-5, except that **H1-35** and **H2-125** were used as a host, and the compound shown in Table 2 below was used for a first hole transport layer.

### [Comparative Example 2-1] OLED produced by an evaporation of HTL-A as a compound for a first hole transport layer

OLED was produced in the same manner as in Device Examples 2-1 to 2-5, except that HTL-A shown below was used as a compound for a first hole transport layer.

A driving voltage at a current density of 10 mA/cm², luminous efficiency, CIE color coordinate, and time taken to be reduced from 100% to 98% of the luminance at 10,000 nit and a constant current (T98 lifespan) of OLEDs produced in device examples 2-1 to 2-10 and comparative example 2-1 are shown in Table 2 below.

**[Table 2]**

| **Device Example No.** | **The first hole transport layer** | **Host** | **Voltage (V)** | **Efficiency (cd/A)** | **Color coordinate (x, y)** | | **T98 Lifespan (hr)** |
|---|---|---|---|---|---|---|---|
| 2-1 | H1-12 | H1-281:H2-125 | 4.4 | 72.9 | 426 | 560 | 29 |
| 2-2 | H1-4 | H1-281:H2-125 | 4.5 | 75.4 | 429 | 557 | 45 |
| 2-3 | H1-28 | H1-281:H2-125 | 4.1 | 74.3 | 427 | 559 | 40 |
| 2-4 | H1-422 | H1-281:H2-125 | 4.2 | 74 | 428 | 559 | 29 |
| 2-5 | H1-137 | H1-281:H2-125 | 4.6 | 76.9 | 426 | 560 | 21 |
| 2-6 | H1-284 | H1-35:H2-125 | 4.5 | 74 | 422 | 563 | 12 |
| 2-7 | H1-35 | H1-35:H2-125 | 4.1 | 75 | 421 | 561 | 26 |
| 2-8 | H1-423 | H1-35:H2-125 | 4.2 | 74.2 | 424 | 562 | 19 |
| 2-9 | H1-288 | H1-35:H2-125 | 4.3 | 75.1 | 421 | 562 | 20 |
| 2-10 | H1-287 | H1-35:H2-125 | 4.2 | 73.8 | 423 | 560 | 33 |
| Comparative Example 2-1 | HTL-A | H1-281:H2-125 | 4.3 | 75.3 | 428 | 558 | 2 |

As confirmed in the Device Examples above, the organic electroluminescent device of the present disclosure has better lifespan characteristics than conventional devices by comprising a specific hole transport compound and a plurality of hosts.

## Claims

1. An organic electroluminescent device comprising an anode, a cathode, and an organic layer between the anode and the cathode, wherein the organic layer comprises one or more light-emitting layers and one or more hole transport layers; at least one of the one or more light-emitting layers comprises one or more dopant compounds and two or more host compounds; **characterized in that** a first host compound of the host compounds is represented by the following formula 1; a second host compound is represented by the following formula 2; and at least one of the one or more hole transport layers comprises the compound represented by the following formula 1: 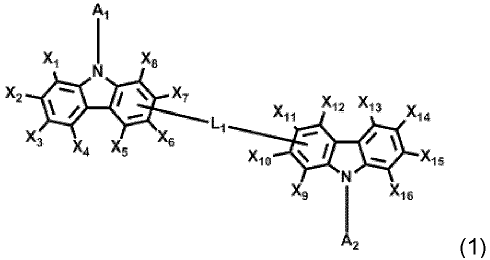 wherein
A₁ and A₂, each independently, represent a substituted or unsubstituted (C6-C30)aryl, provided that a nitrogen-containing heteroaryl is excluded from the substituent of A₁ and A₂;
L₁ represents a single bond or a substituted or unsubstituted (C6-C30)arylene;
X₁ to X₁₆, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3-to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino; or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur; 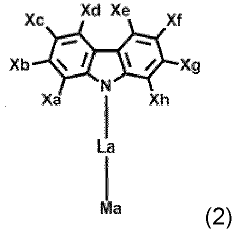
wherein
Ma represents a substituted or unsubstituted monocyclic ring-type heteroaryl selected from the group consisting of a substituted or unsubstituted pyrrolyl, a substituted or unsubstituted imidazolyl, a substituted or unsubstituted pyrazolyl, a substituted or unsubstituted triazinyl, a substituted or unsubstituted tetrazinyl, a substituted or unsubstituted triazolyl, a substituted or unsubstituted tetrazolyl, a substituted or unsubstituted pyrazinyl, a substituted or unsubstituted pyrimidinyl, and a substituted or unsubstituted pyridazinyl, or a substituted or unsubstituted fused ring-type heteroaryl selected from the group consisting of a substituted or unsubstituted benzimidazolyl, a substituted or unsubstituted isoindolyl, a substituted or unsubstituted indolyl, a substituted or unsubstituted indazolyl, a substituted or unsubstituted benzothiadiazolyl, a substituted or unsubstituted quinolyl, a substituted or unsubstituted isoquinolyl, a substituted or unsubstituted cinnolinyl, a substituted or unsubstituted quinazolinyl, a substituted or unsubstituted naphthyridinyl, and a substituted or unsubstituted quinoxalinyl;
La represents a single bond, or a substituted or unsubstituted (C6-C30)arylene;
Xa, and Xc to Xh, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3- to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino;
Xb represents a substituted or unsubstituted dibenzofuranyl or a substituted or unsubstituted dibenzothiophenyl; and
the heteroaryl contains at least one hetero atom selected from B, N, O, S, Si, and P.

2. The organic electroluminescent device according to claim 1, wherein in formula 1, A₁ and A₂, each independently, are selected from the group consisting of a substituted or unsubstituted phenyl, a substituted or unsubstituted biphenyl, a substituted or unsubstituted terphenyl, a substituted or unsubstituted naphthyl, a substituted or unsubstituted fluorenyl, a substituted or unsubstituted benzofluorenyl, a substituted or unsubstituted phenanthrenyl, a substituted or unsubstituted anthracenyl, a substituted or unsubstituted indenyl, a substituted or unsubstituted triphenylenyl, a substituted or unsubstituted pyrenyl, a substituted or unsubstituted tetracenyl, a substituted or unsubstituted perylenyl, a substituted or unsubstituted chrysenyl, a substituted or unsubstituted phenylnaphthyl, a substituted or unsubstituted naphthylphenyl, and a substituted or unsubstituted fluoranthenyl.

3. The organic electroluminescent device according to claim 1, wherein in formula 1, L₁ represents a single bond, or one selected from the following formulae 7 to 19. 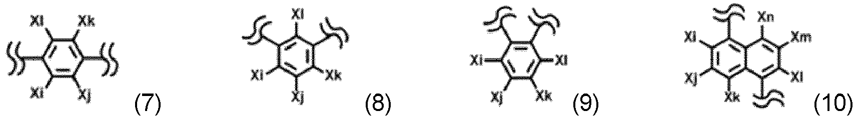 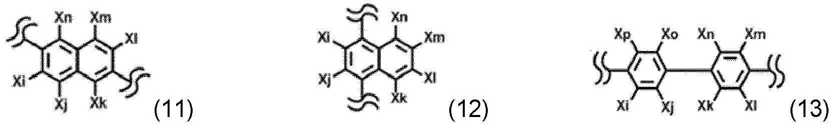 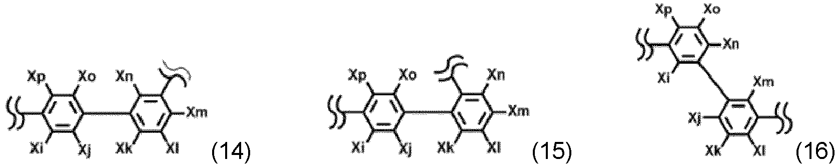 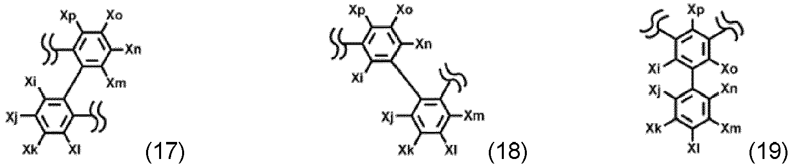 wherein
Xi to Xp, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3-to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino; or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur; and 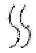 represents a bonding site to a mother nucleus.

4. The organic electroluminescent device according to claim 1, wherein in formula 2, La represents a single bond, or one selected from the following formulae 7 to 19. 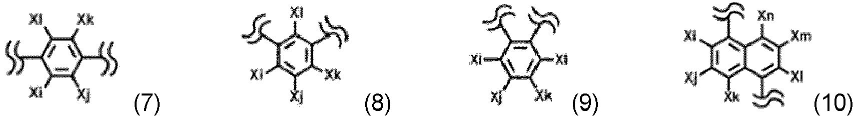 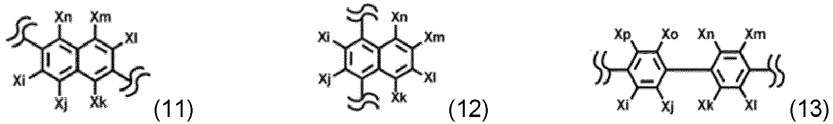 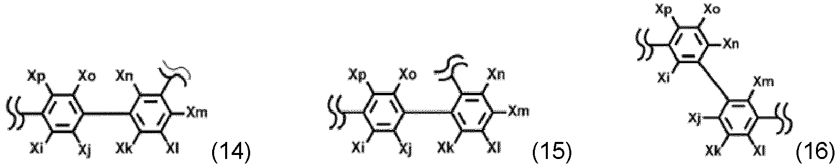 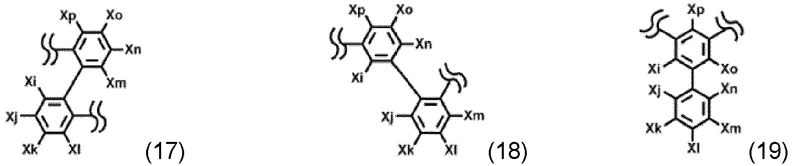 wherein
Xi to Xp, each independently, represent hydrogen, deuterium, a halogen, a cyano, a substituted or unsubstituted (C1-C30)alkyl, a substituted or unsubstituted (C2-C30)alkenyl, a substituted or unsubstituted (C2-C30)alkynyl, a substituted or unsubstituted (C3-C30)cycloalkyl, a substituted or unsubstituted (C6-C60)aryl, a substituted or unsubstituted 3-to 30-membered heteroaryl, a substituted or unsubstituted tri(C1-C30)alkylsilyl, a substituted or unsubstituted tri(C6-C30)arylsilyl, a substituted or unsubstituted di(C1-C30)alkyl(C6-C30)arylsilyl, a substituted or unsubstituted (C1-C30)alkyldi(C6-C30)arylsilyl, or a substituted or unsubstituted mono- or di-(C6-C30)arylamino; or may be linked to an adjacent substituent(s) to form a substituted or unsubstituted (C3-C30), mono- or polycyclic, alicyclic or aromatic ring, whose carbon atom(s) may be replaced with at least one hetero atom selected from nitrogen, oxygen, and sulfur; and 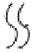 represents a bonding site to a mother nucleus.

5. The organic electroluminescent device according to claim 1, wherein in formula 2, Xa and Xc to Xh, each independently, represent hydrogen, a cyano, a (C6-C15)aryl unsubstituted or substituted with a tri(C6-C10)arylsilyl, or a 10- to 20-membered heteroaryl unsubstituted or substituted with a (C6-C12)aryl.

6. The organic electroluminescent device according to claim 1, wherein the compound of formula 1 is selected from the group consisting of:

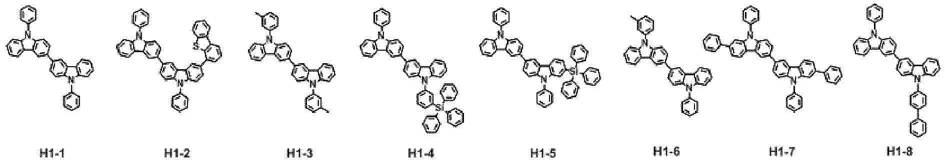

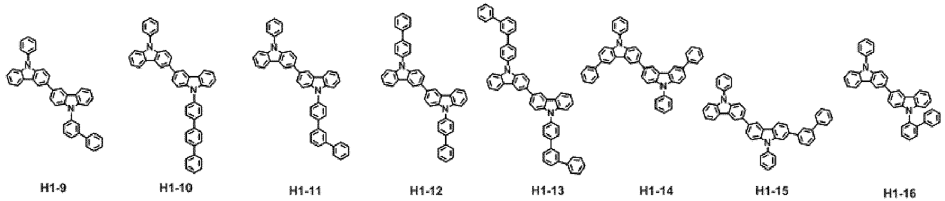

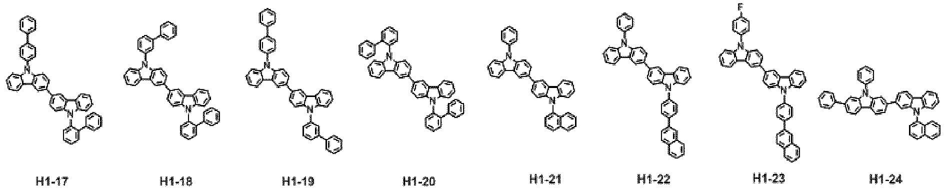

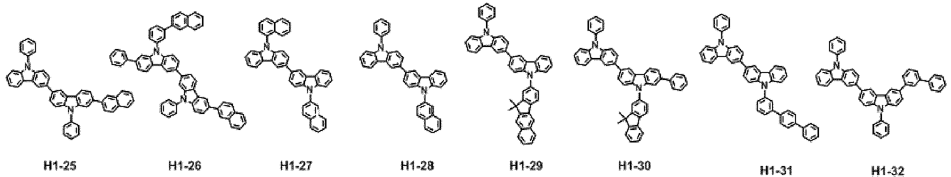

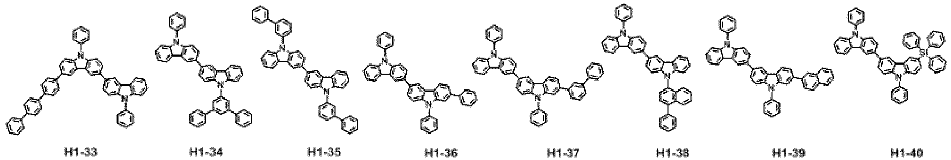

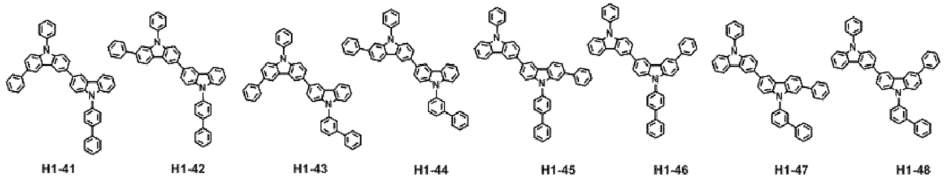

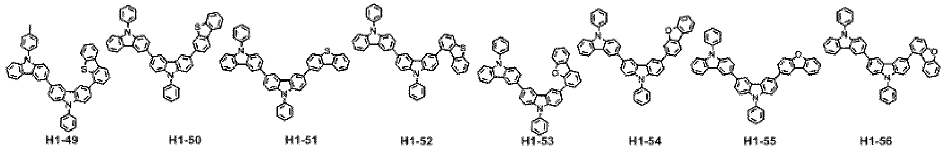

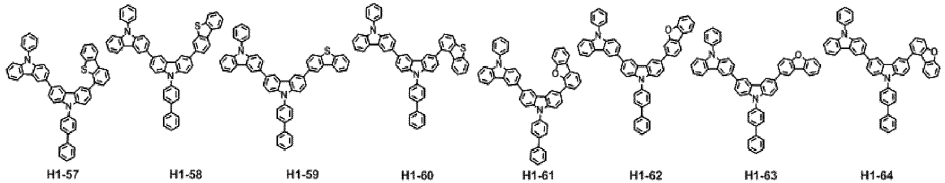

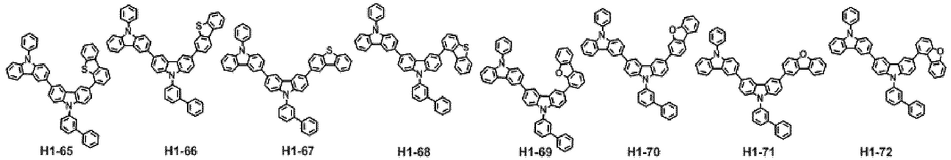

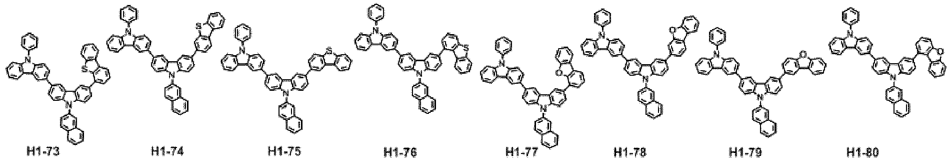

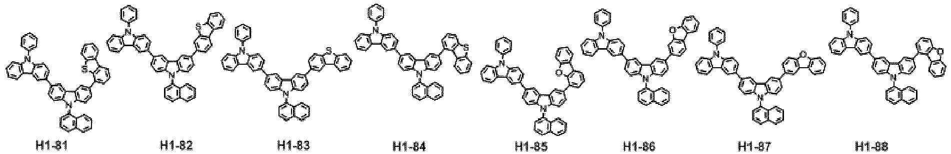

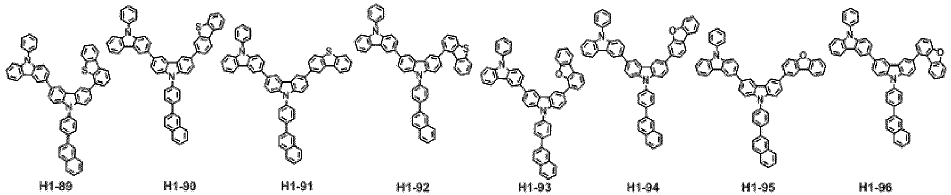

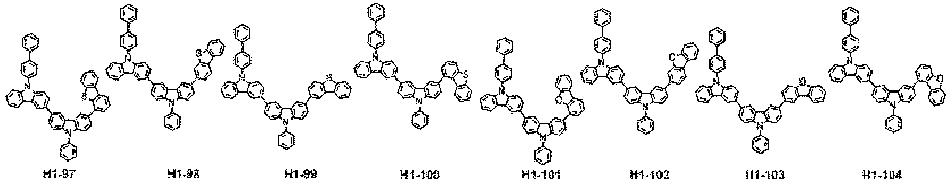

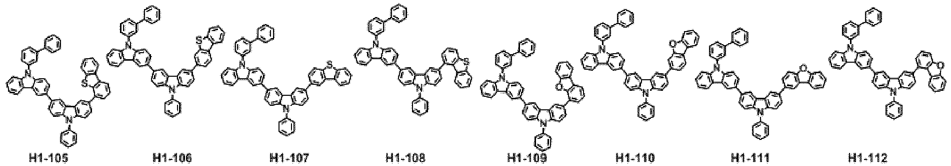

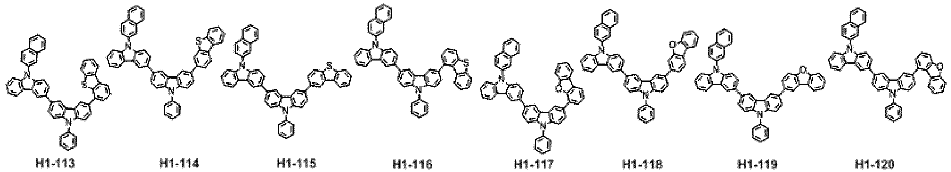

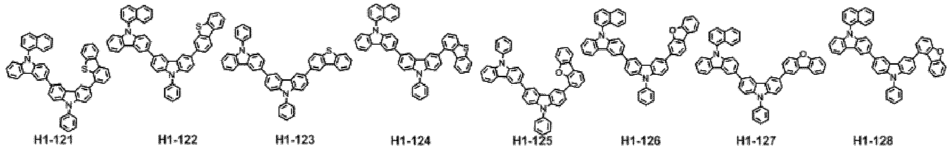

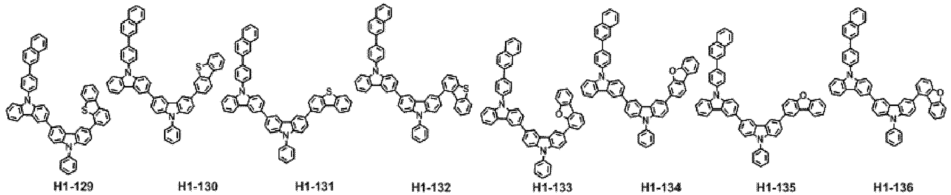

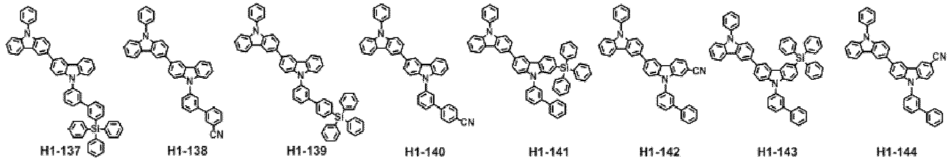

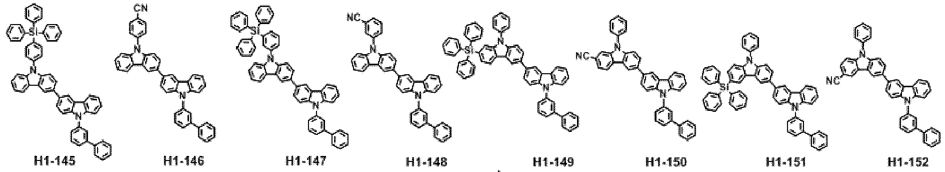

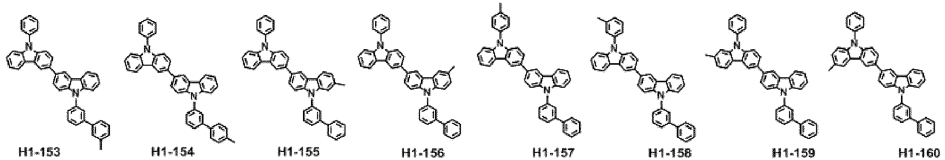

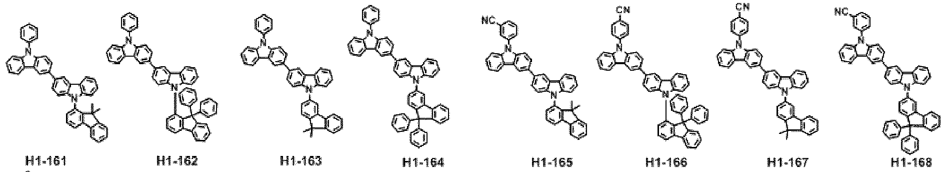

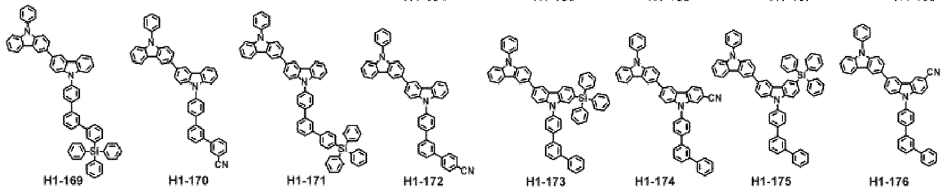

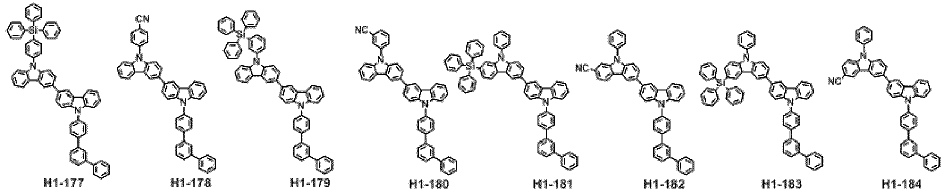

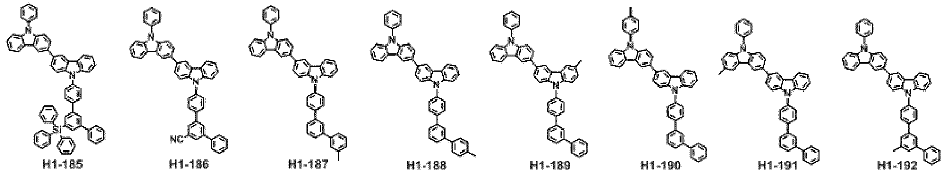

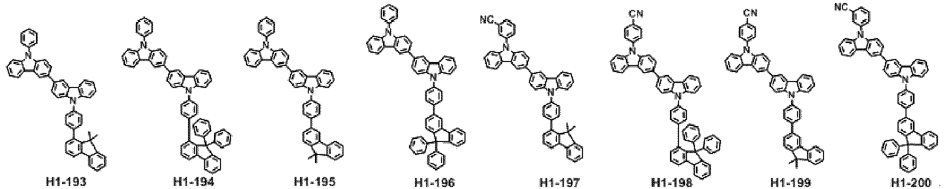

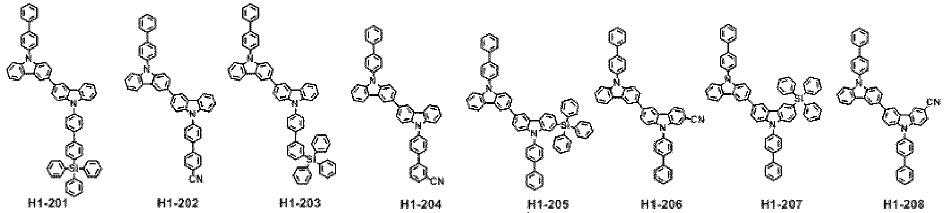

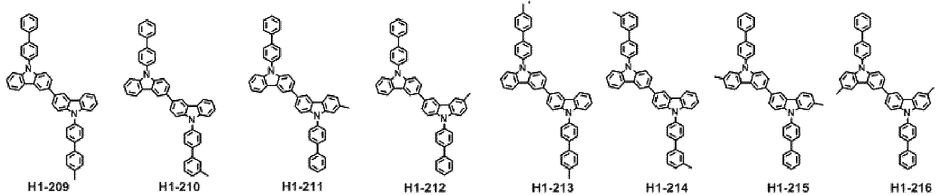

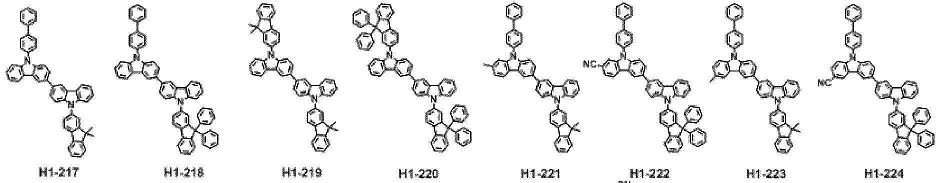

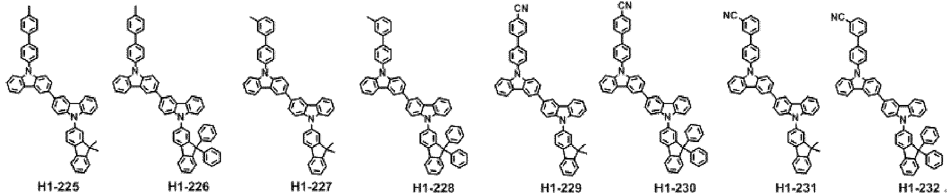

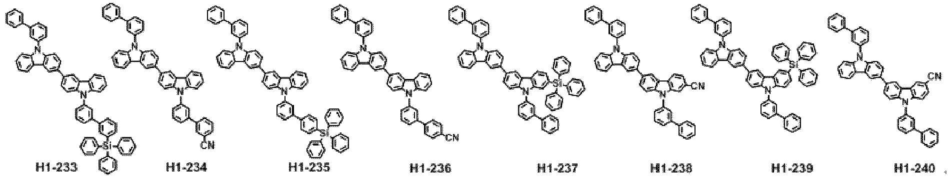

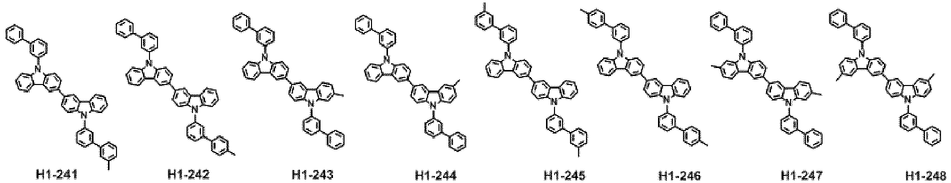

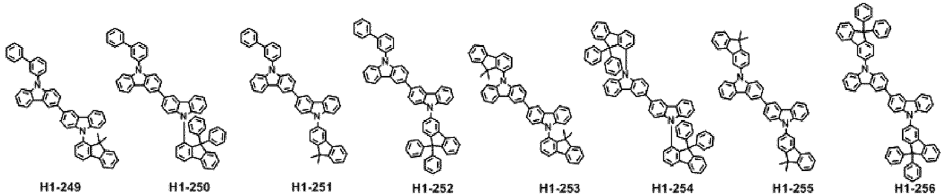

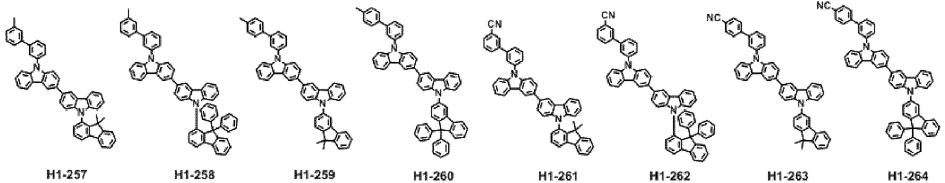

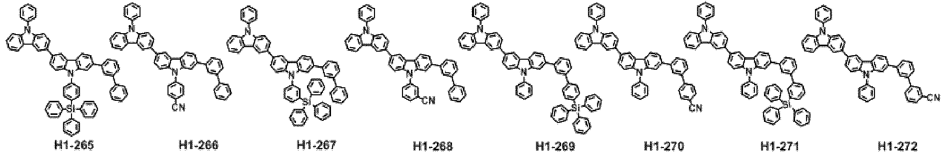

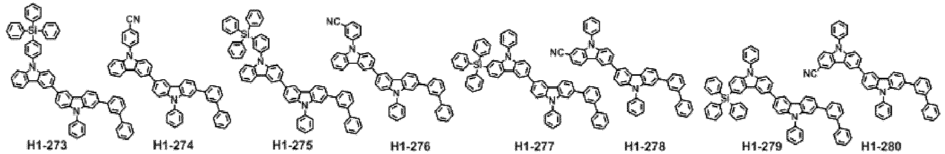

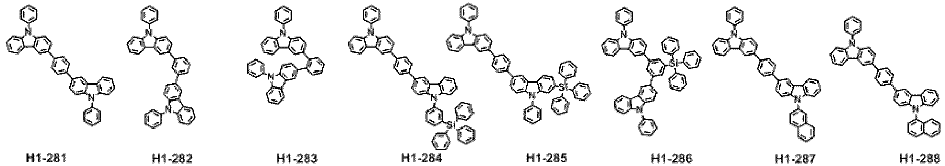

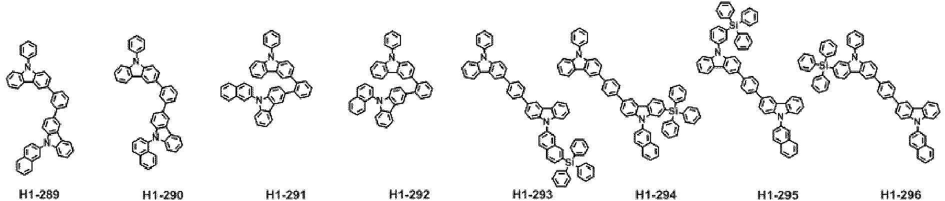

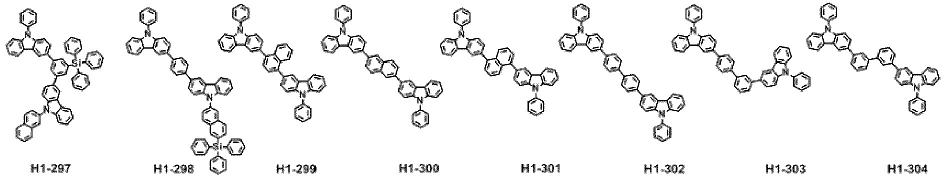

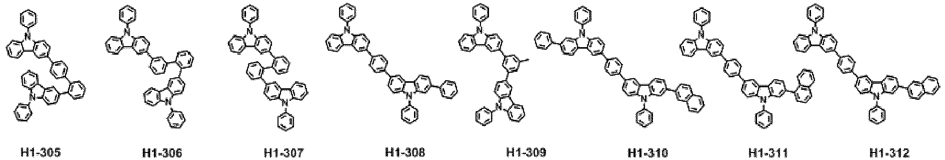

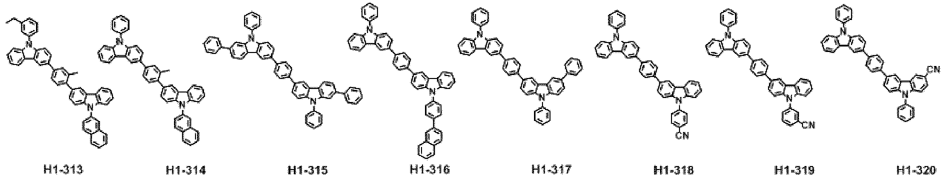

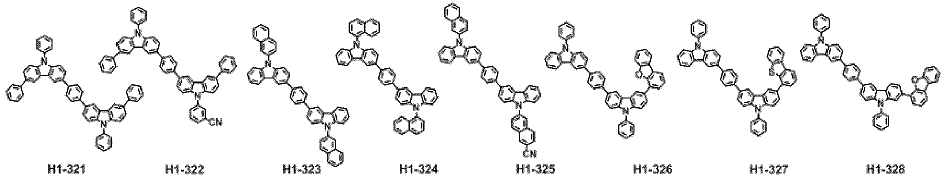

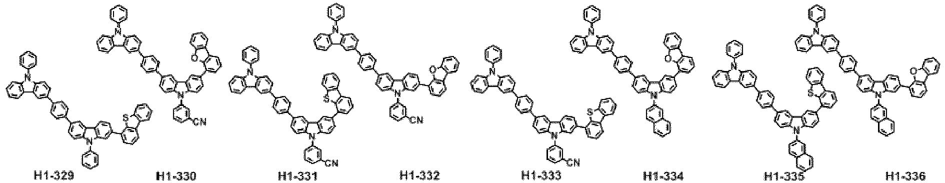

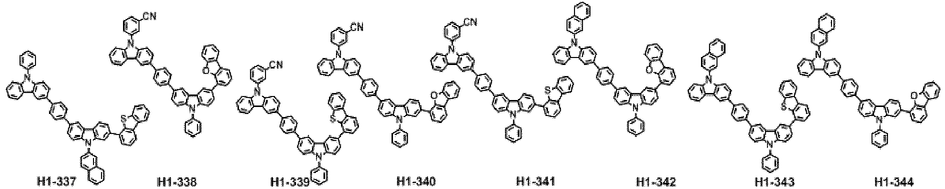

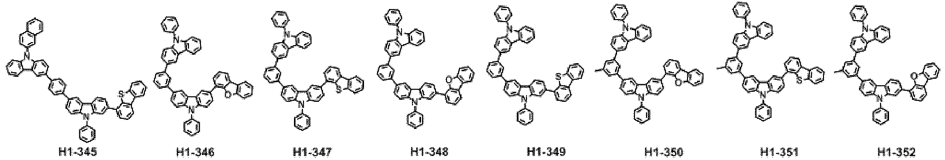

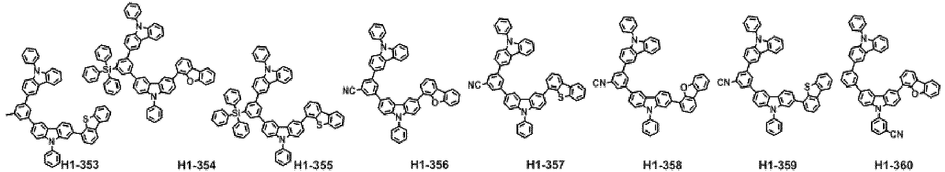

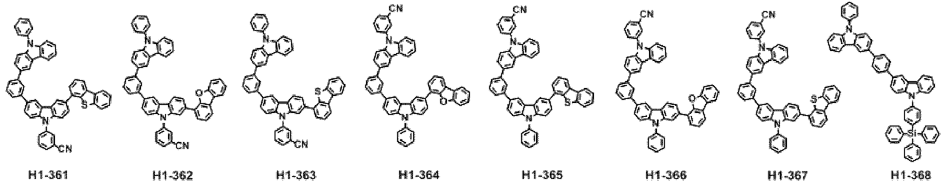

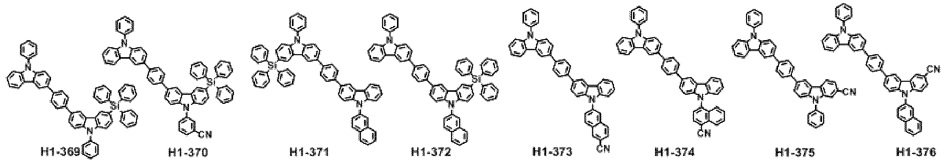

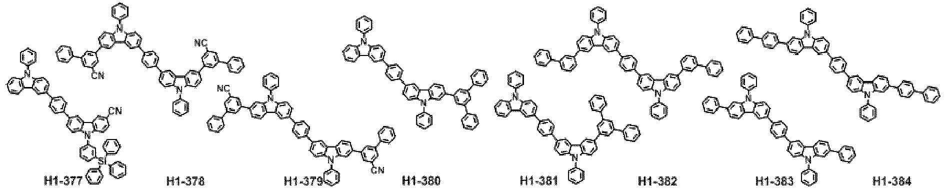

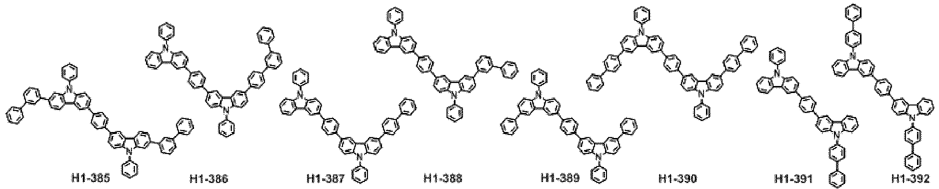

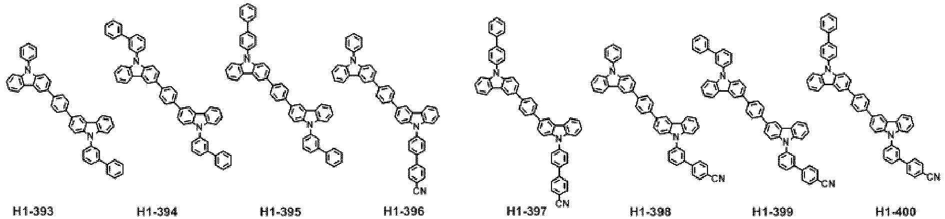

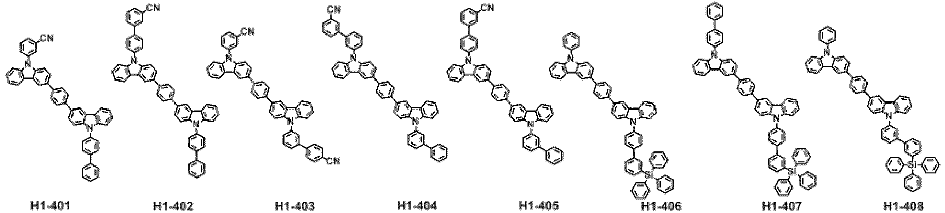

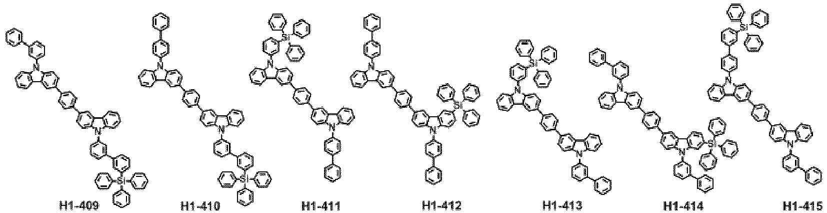

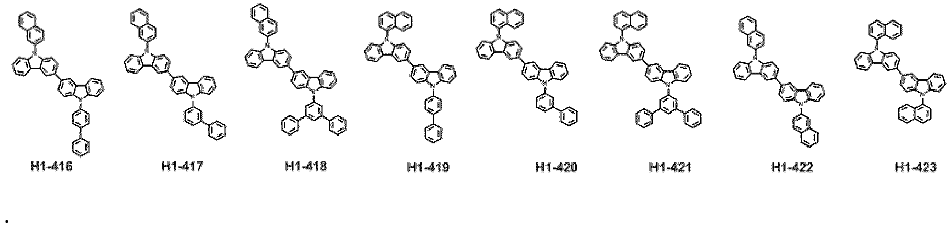

7. The organic electroluminescent device according to claim 1, wherein the compound of formula 2 is selected from the group consisting of:

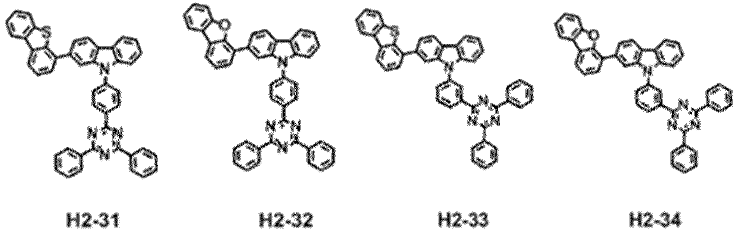

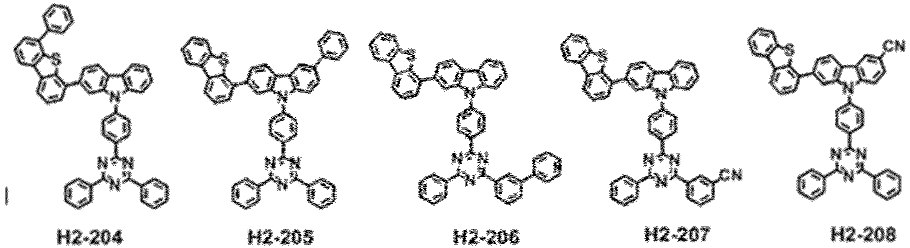

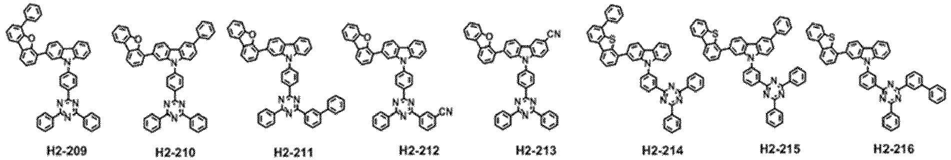

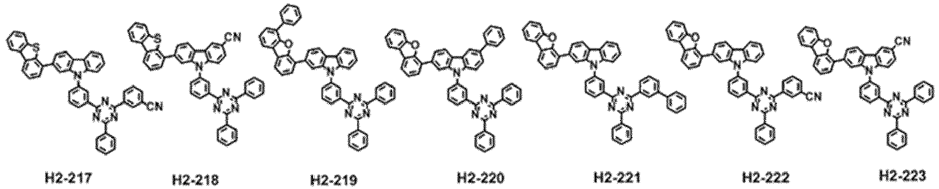

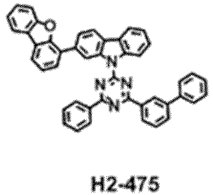

## Patentansprüche

1. Organische Elektrolumineszenzvorrichtung, umfassend eine Anode, eine Kathode und eine organische Schicht zwischen der Anode und der Kathode, wobei die organische Schicht eine oder mehrere lichtemittierende Schichten und eine oder mehrere Lochtransportschichten umfasst, mindestens eine der einen oder mehreren lichtemittierenden Schichten eine oder mehrere Dotierstoffverbindungen und zwei oder mehr Wirtsverbindungen umfasst, **dadurch gekennzeichnet, dass** eine erste Wirtsverbindung der Wirtsverbindungen durch die folgende Formel 1 dargestellt ist, eine zweite Wirtsverbindung durch die folgende Formel 2 dargestellt ist und mindestens eine der einen oder mehreren Lochtransportschichten die Verbindung umfasst, die durch die folgende Formel 1 dargestellt ist: 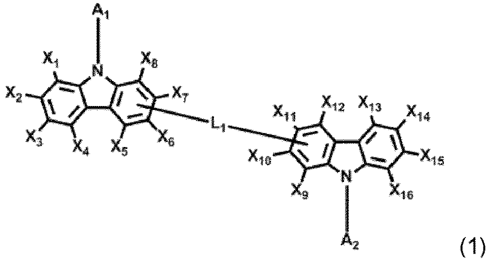 wobei
A₁ und A₂ jeweils unabhängig ein substituiertes oder unsubstituiertes (C6-C30)Aryl darstellen, mit der Maßgabe, dass ein stickstoffhaltiges Heteroaryl aus dem Substituenten von A1 und A2 ausgeschlossen ist,
L₁ eine einzelne Bindung oder ein substituiertes oder unsubstituiertes (C6-C30)Arylen darstellt,
X₁ bis X₁₆ jeweils unabhängig Wasserstoff, Deuterium, ein Halogen, ein Cyano, ein substituiertes oder unsubstituiertes (C1-C30)Alkyl, ein substituiertes oder unsubstituiertes (C2-C30)Alkenyl, ein substituiertes oder unsubstituiertes (C2-C30)Alkynyl, ein substituiertes oder unsubstituiertes (C3-C30)Cycloalkyl, ein substituiertes oder unsubstituiertes (C6-C60)Aryl, ein substituiertes oder unsubstituiertes 3- bis 30-gliedriges Heteroaryl, ein substituiertes oder unsubstituiertes Tri-(C1-C30)alkylsilyl, ein substituiertes oder unsubstituiertes Tri-(C6-C30)arylsilyl, ein substituiertes oder unsubstituiertes Di-(C1-C30)alkyl(C6-C30)arylsilyl, ein substituiertes oder unsubstituiertes (C1-C30)Alkyldi(C6-C30)arylsilyl oder ein substituiertes oder unsubstituiertes Mono- oder Di-(C6-C30)arylamino darstellen oder mit (einem) benachbarten Substituenten verknüpft sein können, um einen substituierten oder unsubstituierten (C3-C30)-, mono- oder polycyclischen, alicyclischen oder aromatischen Ring zu bilden, dessen Kohlenstoffatom(e) durch mindestens ein Heteroatom ersetzt sein können, das aus Stickstoff, Sauerstoff und Schwefel ausgewählt ist, 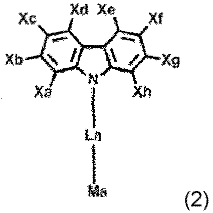
wobei
Ma ein substituiertes oder unsubstituiertes Heteroaryl vom monocyclischen Ringtyp darstellt, das ausgewählt ist aus der Gruppe bestehend aus einem substituierten oder unsubstituierten Pyrrolyl, einem substituierten oder unsubstituierten Imidazolyl, einem substituierten oder unsubstituierten Pyrazolyl, einem substituierten oder unsubstituierten Triazinyl, einem substituierten oder unsubstituierten Tetrazinyl, einem substituierten oder unsubstituierten Triazolyl, einem substituierten oder unsubstituierten Tetrazolyl, einem substituierten oder unsubstituierten Pyrazinyl, einem substituierten oder unsubstituierten Pyrimidinyl und einem substituierten oder unsubstituierten Pyridazinyl, oder ein substituiertes oder unsubstituiertes Heteroaryl vom kondensierten Ringtyp, das ausgewählt ist aus der Gruppe bestehend aus einem substituierten oder unsubstituierten Benzimidazolyl, einem substituierten oder unsubstituierten Isoindolyl, einem substituierten oder unsubstituierten Indolyl, einem substituierten oder unsubstituierten Indazolyl, einem substituierten oder unsubstituierten Benzothiadiazolyl, einem substituierten oder unsubstituierten Chinolyl, einem substituierten oder unsubstituierten Isochinolyl, einem substituierten oder unsubstituierten Cinnolinyl, einem substituierten oder unsubstituierten Chinazolinyl, einem substituierten oder unsubstituierten Naphthyridinyl und einem substituierten oder unsubstituierten Chinoxalinyl,
La eine einzelne Bindung oder ein substituiertes oder unsubstituiertes (C6-C30)Arylen darstellt,
Xa, und Xc bis Xh jeweils unabhängig Wasserstoff, Deuterium, ein Halogen, ein Cyano, ein substituiertes oder unsubstituiertes (C1-C30)Alkyl, ein substituiertes oder unsubstituiertes (C2-C30)Alkenyl, ein substituiertes oder unsubstituiertes (C2-C30)Alkynyl, ein substituiertes oder unsubstituiertes (C3-C30)Cycloalkyl, ein substituiertes oder unsubstituiertes (C6-C60)Aryl, ein substituiertes oder unsubstituiertes 3- bis 30-gliedriges Heteroaryl, ein substituiertes oder unsubstituiertes Tri-(C1-C30)alkylsilyl, ein substituiertes oder unsubstituiertes Tri-(C6-C30)arylsilyl, ein substituiertes oder unsubstituiertes Di-(C1-C30)alkyl(C6-C30)arylsilyl, ein substituiertes oder unsubstituiertes (C1-C30)Alkyldi(C6-C30)arylsilyl oder ein substituiertes oder unsubstituiertes Mono- oder Di-(C6-C30)arylamino darstellen,
Xb ein substituiertes oder unsubstituiertes Dibenzofuranyl oder ein substituiertes oder unsubstituiertes Dibenzothiophenyl darstellt, und
das Heteroaryl mindestens ein Heteroatom enthält, das aus B, N, O, S, Si und P ausgewählt ist.

2. Organische Elektrolumineszenzvorrichtung nach Anspruch 1, wobei in Formel 1 A₁ und A₂ jeweils unabhängig aus der Gruppe ausgewählt sind bestehend aus einem substituierten oder unsubstituierten Phenyl, einem substituierten oder unsubstituierten Biphenyl, einem substituierten oder unsubstituierten Terphenyl, einem substituierten oder unsubstituierten Naphthyl, einem substituierten oder unsubstituierten Fluorenyl, einem substituierten oder unsubstituierten Benzofluorenyl, einem substituierten oder unsubstituierten Phenanthrenyl, einem substituierten oder unsubstituierten Anthracenyl, einem substituierten oder unsubstituierten Indenyl, einem substituierten oder unsubstituierten Triphenylenyl, einem substituierten oder unsubstituierten Pyrenyl, einem substituierten oder unsubstituierten Tetracenyl, einem substituierten oder unsubstituierten Perylenyl, einem substituierten oder unsubstituierten Chrysenyl, einem substituierten oder unsubstituierten Phenylnaphthyl, einem substituierten oder unsubstituierten Naphthylphenyl und einem substituierten oder unsubstituierten Fluoranthenyl.

3. Organische Elektrolumineszenzvorrichtung nach Anspruch 1, wobei in Formel 1 L₁ eine einzelne Bindung darstellt oder eines, das aus den folgenden Formeln 7 bis 19 ausgewählt ist: 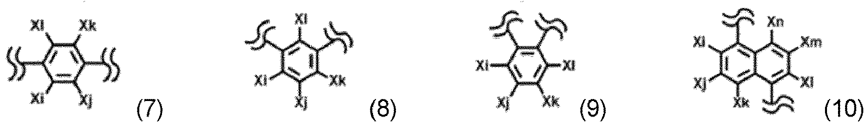 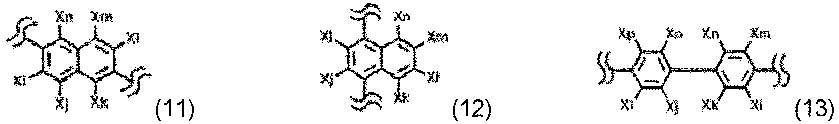 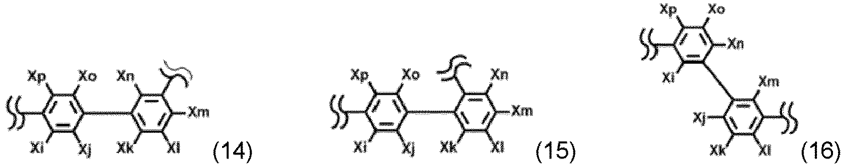 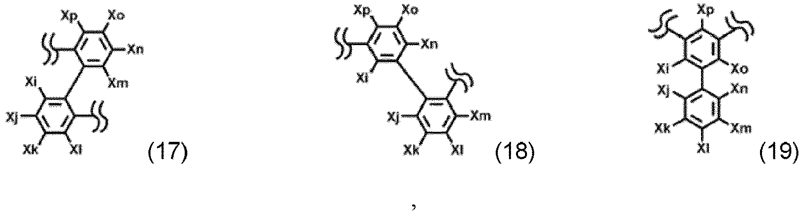 wobei
Xi bis Xp jeweils unabhängig Wasserstoff, Deuterium, ein Halogen, ein Cyano, ein substituiertes oder unsubstituiertes (C1-C30)Alkyl, ein substituiertes oder unsubstituiertes (C2-C30)Alkenyl, ein substituiertes oder unsubstituiertes (C2-C30)Alkynyl, ein substituiertes oder unsubstituiertes (C3-C30)Cycloalkyl, ein substituiertes oder unsubstituiertes (C6-C60)Aryl, ein substituiertes oder unsubstituiertes 3- bis 30-gliedriges Heteroaryl, ein substituiertes oder unsubstituiertes Tri-(C1-C30)alkylsilyl, ein substituiertes oder unsubstituiertes Tri-(C6-C30)arylsilyl, ein substituiertes oder unsubstituiertes Di-(C1-C30)alkyl(C6-C30)arylsilyl, ein substituiertes oder unsubstituiertes (C1-C30)Alkyldi(C6-C30)arylsilyl oder ein substituiertes oder unsubstituiertes Mono- oder Di-(C6-C30)arylamino darstellen oder mit (einem) benachbarten Substituenten verknüpft sein können, um einen substituierten oder unsubstituierten (C3-C30)-, mono- oder polycyclischen, alicyclischen oder aromatischen Ring zu bilden, dessen Kohlenstoffatom(e) durch mindestens ein Heteroatom ersetzt sein können, das aus Stickstoff, Sauerstoff und Schwefel ausgewählt ist, und 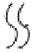 eine Bindungsstelle mit einem Mutterkern darstellt.

4. Organische Elektrolumineszenzvorrichtung nach Anspruch 1, wobei in Formel 2 La eine einzelne Bindung darstellt oder eines, das aus den folgenden Formeln 7 bis 19 ausgewählt ist: 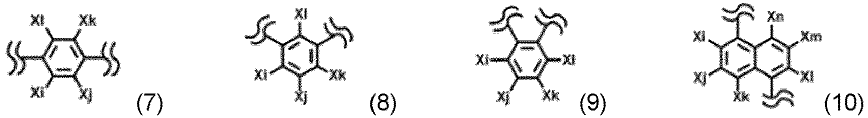 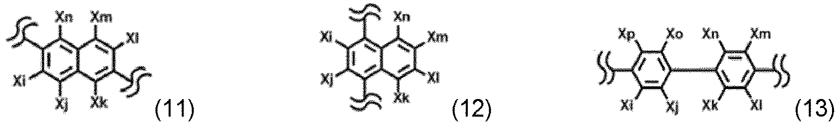 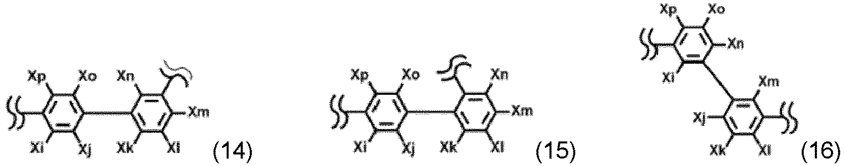 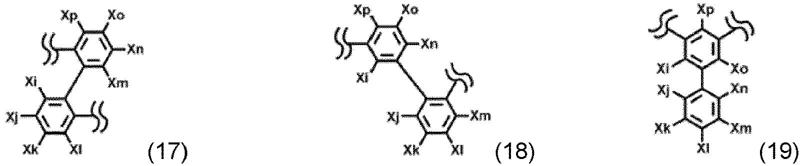 wobei
Xi bis Xp jeweils unabhängig Wasserstoff, Deuterium, ein Halogen, ein Cyano, ein substituiertes oder unsubstituiertes (C1-C30)Alkyl, ein substituiertes oder unsubstituiertes (C2-C30)Alkenyl, ein substituiertes oder unsubstituiertes (C2-C30)Alkynyl, ein substituiertes oder unsubstituiertes (C3-C30)Cycloalkyl, ein substituiertes oder unsubstituiertes (C6-C60)Aryl, ein substituiertes oder unsubstituiertes 3- bis 30-gliedriges Heteroaryl, ein substituiertes oder unsubstituiertes Tri-(C1-C30)alkylsilyl, ein substituiertes oder unsubstituiertes Tri-(C6-C30)arylsilyl, ein substituiertes oder unsubstituiertes Di-(C1-C30)alkyl(C6-C30)arylsilyl, ein substituiertes oder unsubstituiertes (C1-C30)Alkyldi(C6-C30)arylsilyl oder ein substituiertes oder unsubstituiertes Mono- oder Di-(C6-C30)arylamino darstellen oder mit (einem) benachbarten Substituenten verknüpft sein können, um einen substituierten oder unsubstituierten (C3-C30)-, mono- oder polycyclischen, alicyclischen oder aromatischen Ring zu bilden, dessen Kohlenstoffatom(e) durch mindestens ein Heteroatom ersetzt sein können, das aus Stickstoff, Sauerstoff und Schwefel ausgewählt ist, und 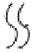 eine Bindungsstelle mit einem Mutterkern darstellt.

5. Organische Elektrolumineszenzvorrichtung nach Anspruch 1, wobei in Formel 2 Xa und Xc bis Xh jeweils unabhängig Wasserstoff, ein Cyano, ein (C6-C15)Aryl, das unsubstituiert oder mit einem Tri(C6-C10)arylsilyl substituiert ist, oder ein 10- bis 20-gliedriges Heteroaryl ist, das unsubstituiert oder mit einem (C6-C12)Aryl substituiert ist, darstellen.

6. Organische Elektrolumineszenzvorrichtung nach Anspruch 1, wobei die Verbindung von Formel 1 ausgewählt ist aus der Gruppe bestehend aus:

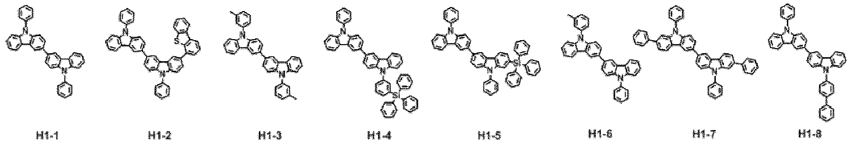

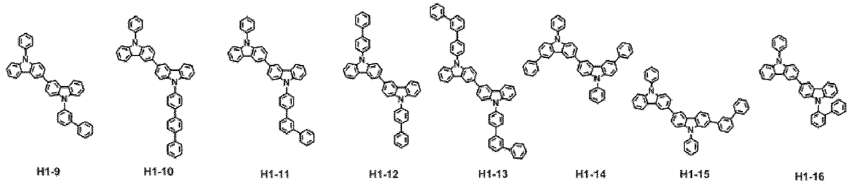

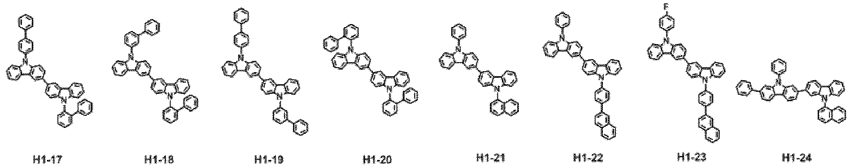

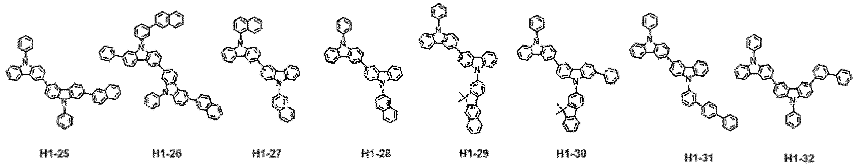

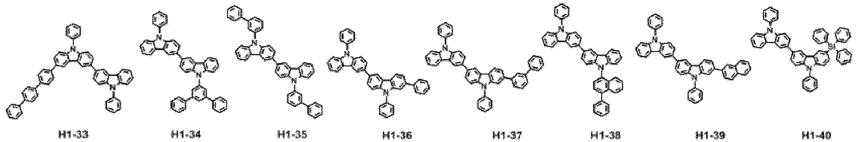

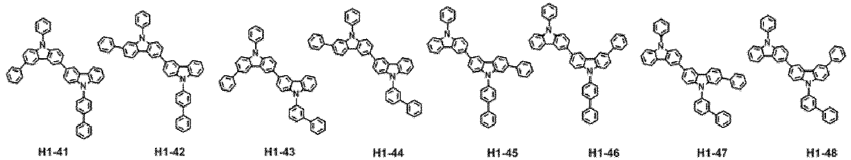

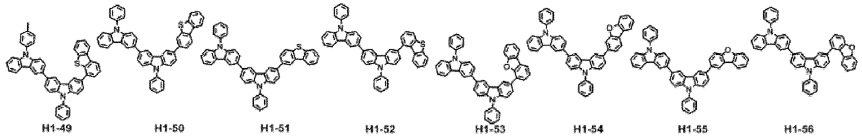

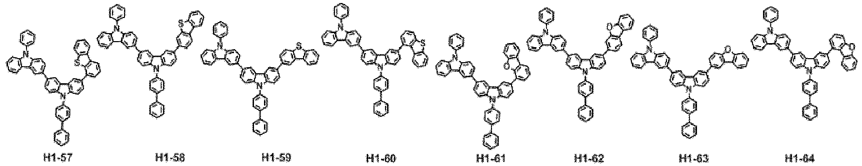

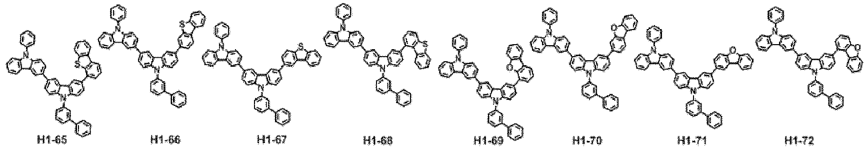

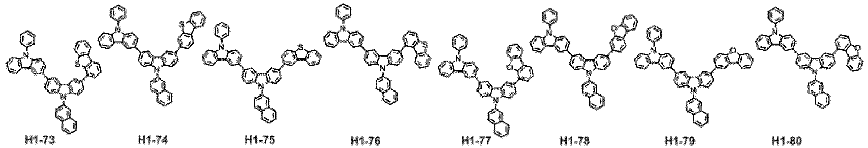

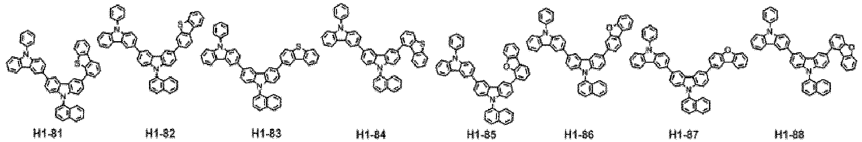

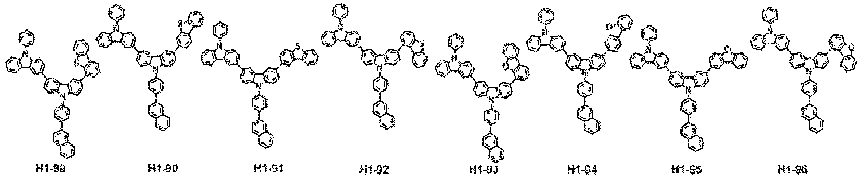

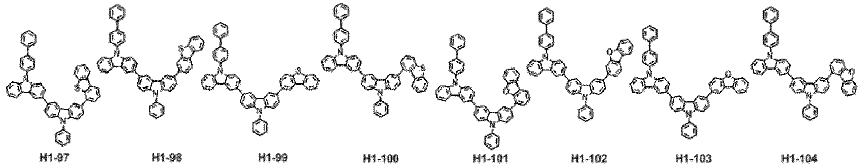

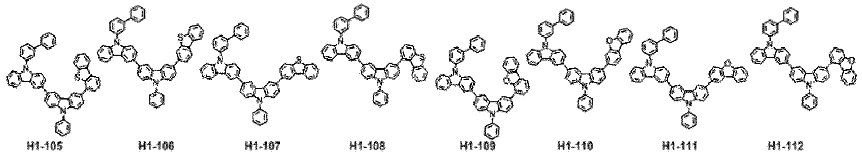

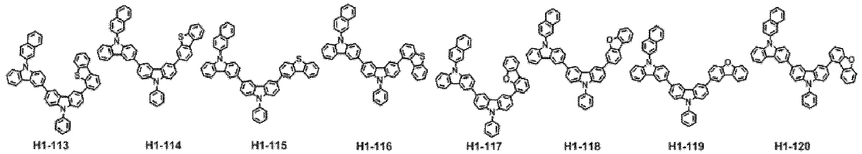

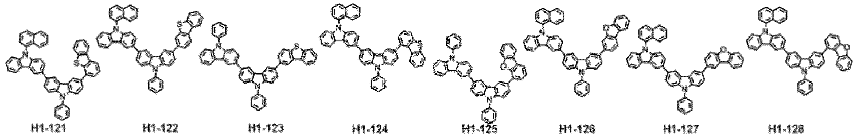

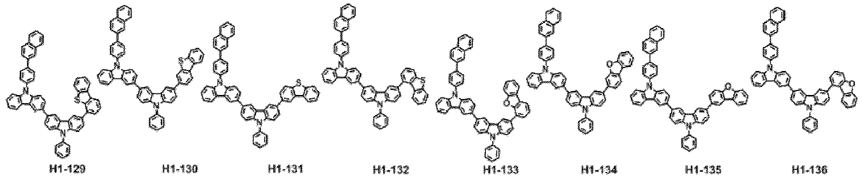

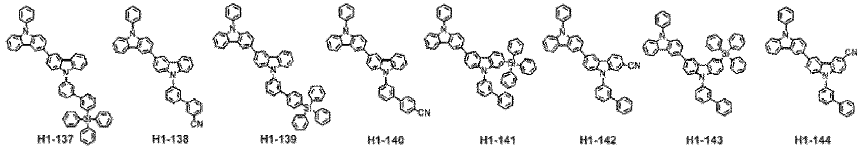

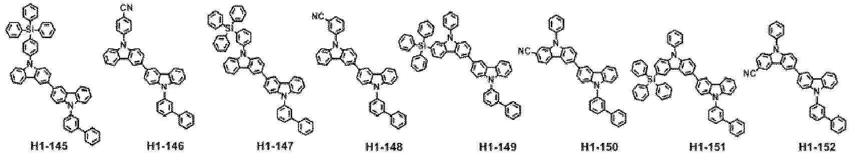

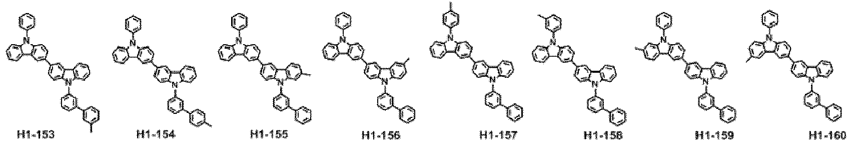

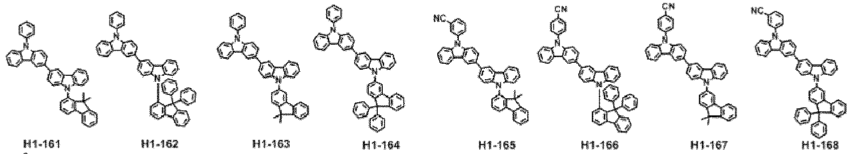

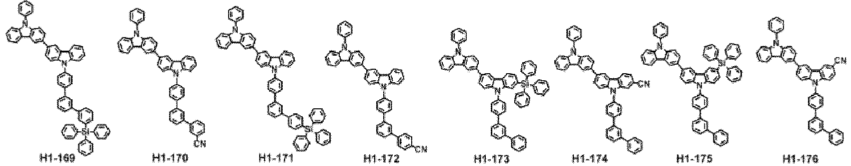

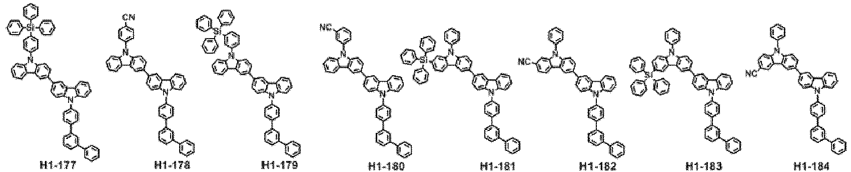

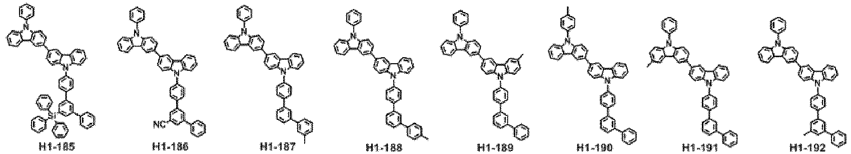

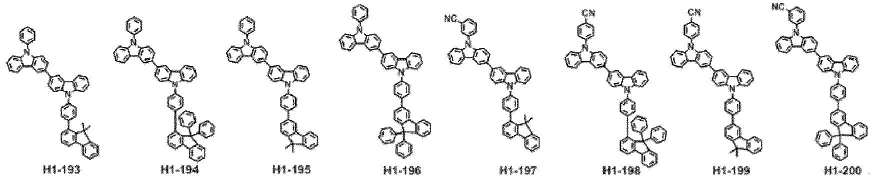

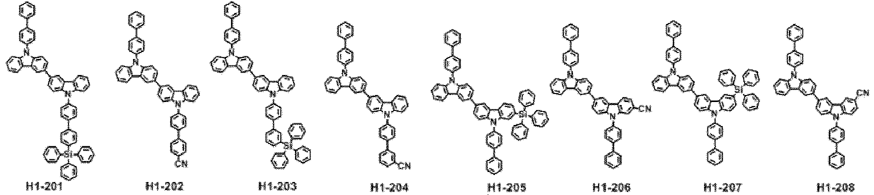

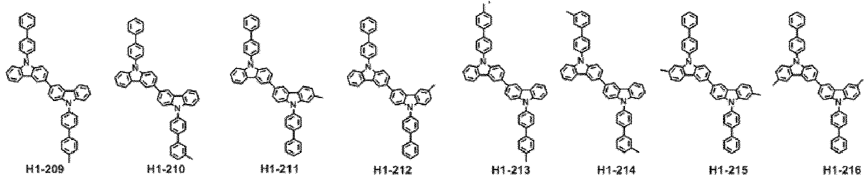

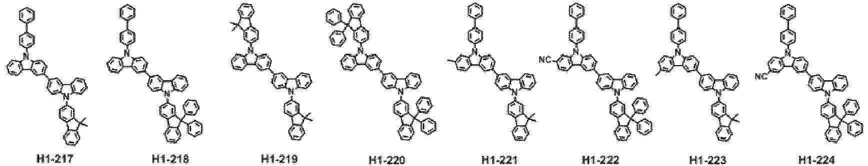

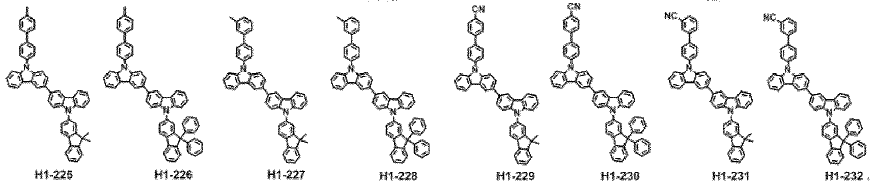

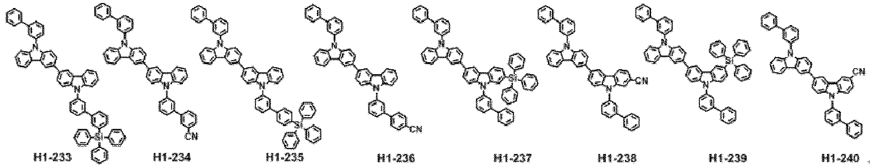

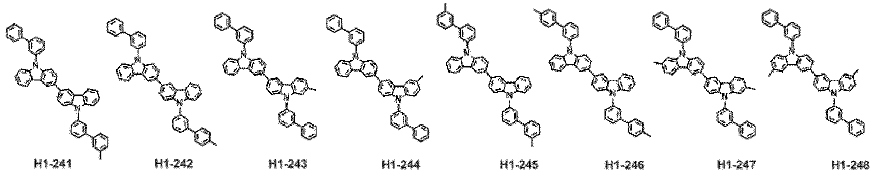

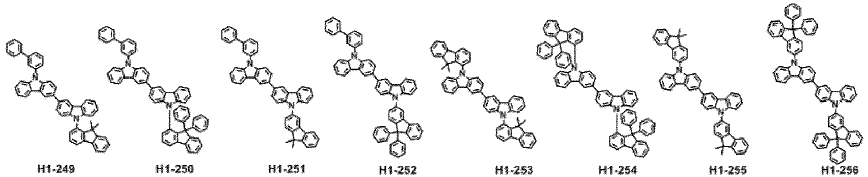

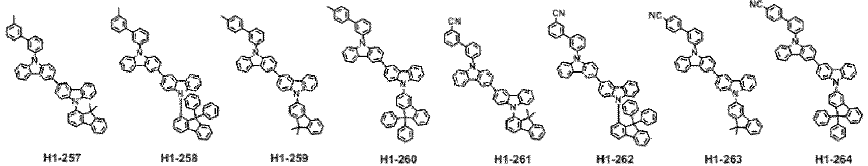

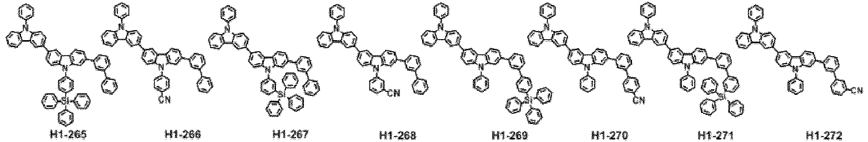

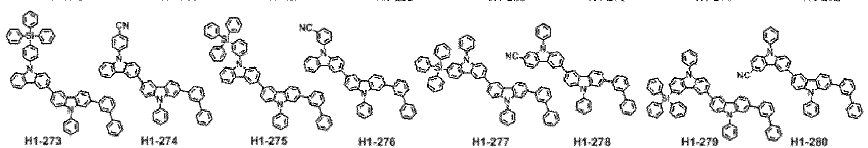

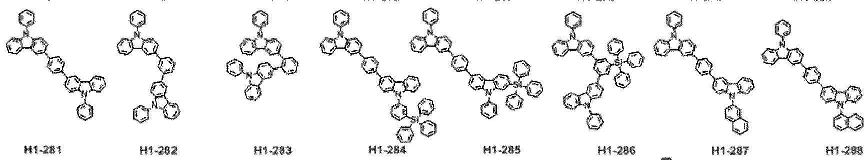

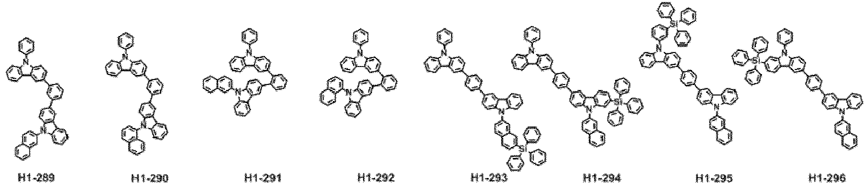

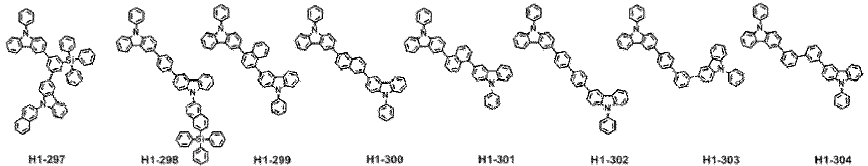

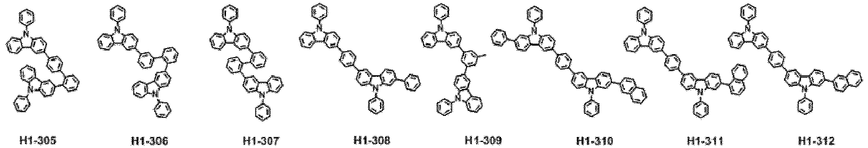

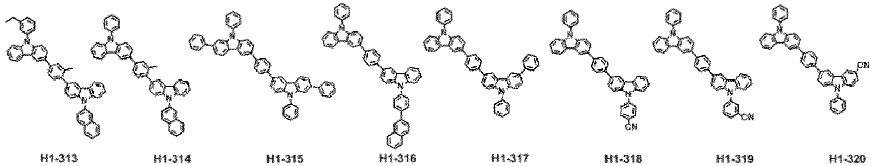

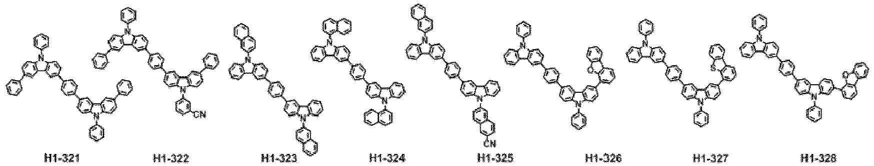

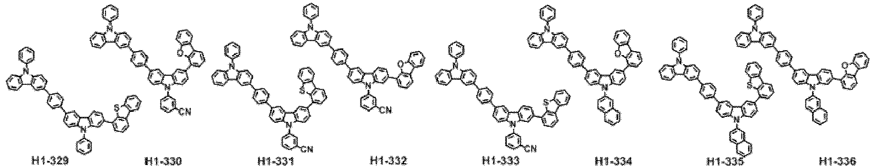

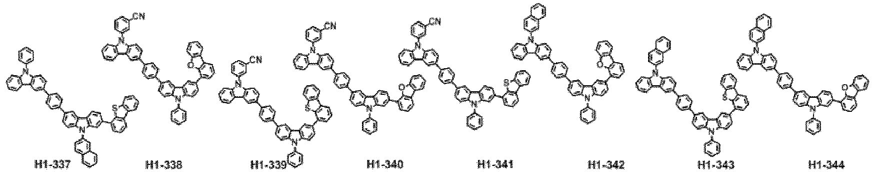

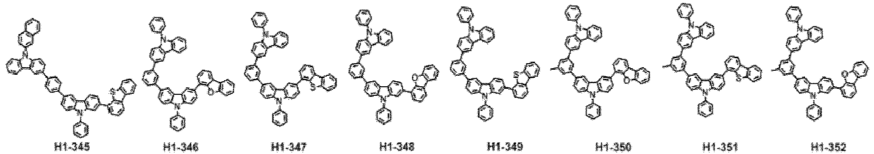

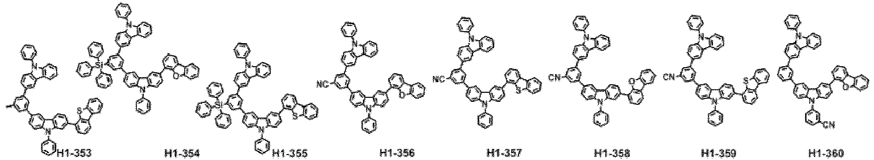

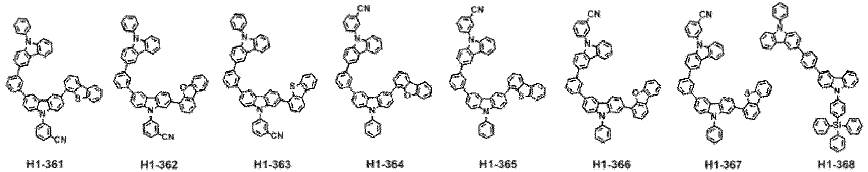

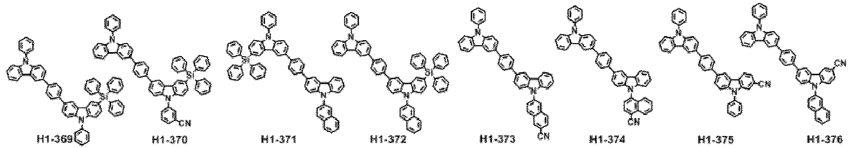

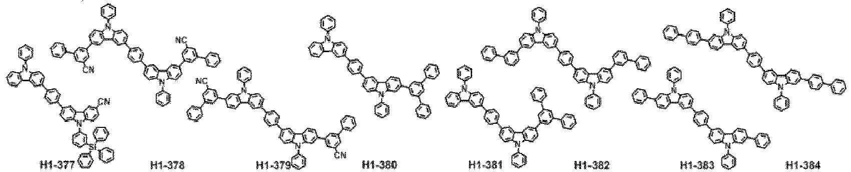

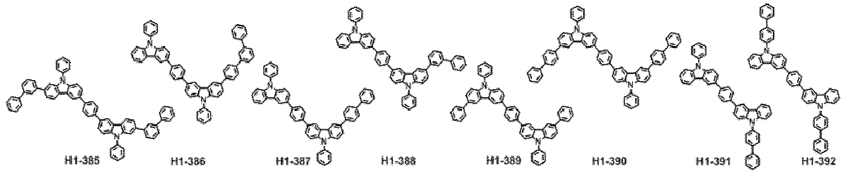

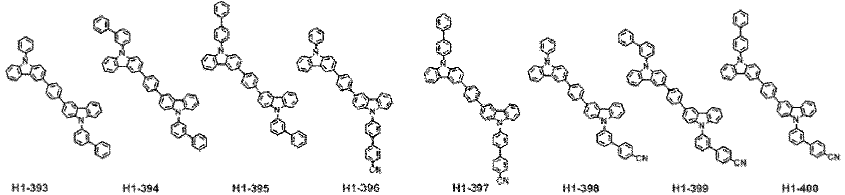

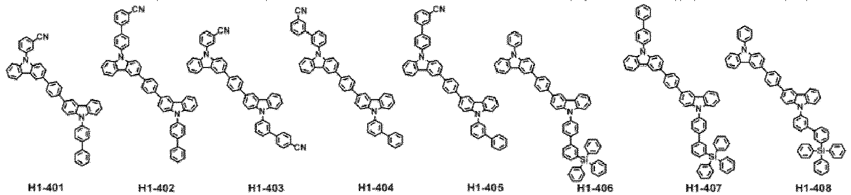

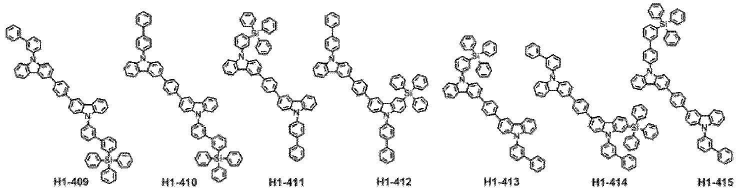

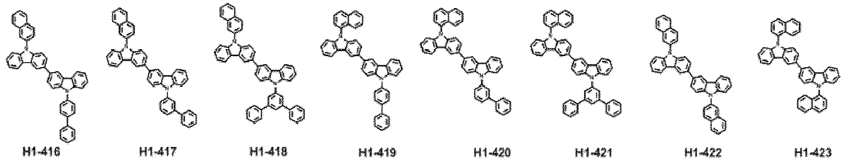

7. Organische Elektrolumineszenzvorrichtung nach Anspruch 1, wobei die Verbindung der Formel 2 ausgewählt ist aus der Gruppe bestehend aus:

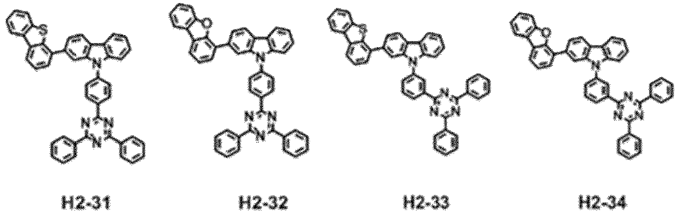

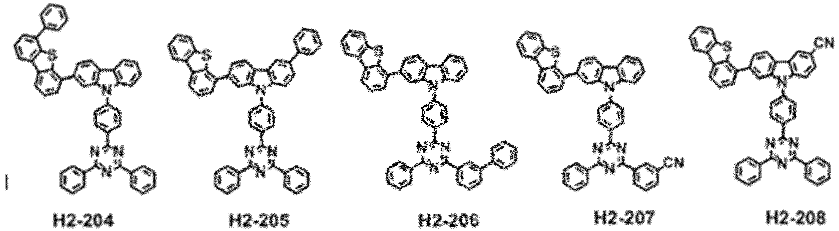

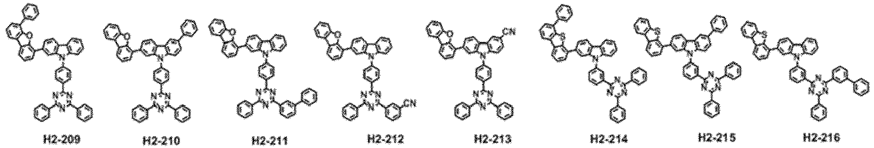

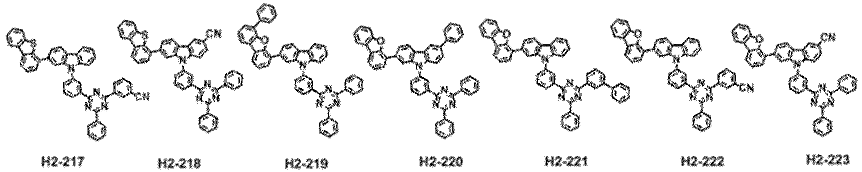

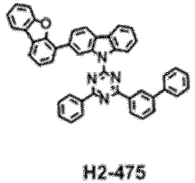

## Revendications

1. Dispositif électroluminescent organique comprenant une anode, une cathode, et une couche organique entre l'anode et la cathode, dans lequel la couche organique comprend une ou plusieurs couches luminescentes et une ou plusieurs couches de transport de trou ; au moins une des une ou plusieurs couches luminescentes comprend un ou plusieurs composés dopants et deux composés hôtes ou plus ; **caractérisé en ce qu'**un premier composé hôte des composés hôtes est représenté par la formule 1 suivante ; un second composé hôte est représenté par la formule 2 suivante ; et au moins une des une ou plusieurs couches de transport de trou comprend le composé représenté par la formule 1 suivante : 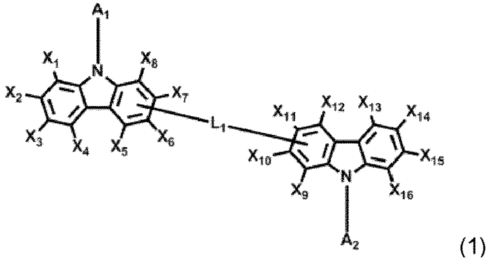 dans lequel :
A₁ et A₂ , chacun indépendamment, représentent un aryle en (C6-C30) substitué ou non substitué, à condition qu'un hétéroaryle contenant de l'azote soit exclu du substituant de A₁ et A₂ ;
L₁ représente une liaison unique ou un arylène en (C6-C30) substitué ou non substitué ;
X₁ à X₁₆, chacun indépendamment, représentent un atome d'hydrogène, un deutérium, un halogène, un cyano, un alkyle en (C1-C30) substitué ou non substitué, un alcényle en (C2-C30) substitué ou non substitué, un alcynyle en (C2-C30) substitué ou non substitué, un cycloalkyle en (C3-C30) substitué ou non substitué, un aryle en (C6-C60) substitué ou non substitué, un hétéroaryle à 3 à 30 éléments substitué ou non substitué, un tri-alkylsilyle en (C1-C30) substitué ou non substitué, un tri-arylsilyle en (C6-C30) substitué ou non substitué, un di-alkyle en (C1-C30)-arylsilyle en (C6-C30) substitué ou non substitué, un alkyle en (C1-C30)-di-arylsilyle en (C6-C30) substitué ou non substitué, ou un mono- ou di-arylamino en (C6-C30) substitué ou non substitué ; ou ils peuvent être liés à un (des) substituant(s) adjacent(s) pour former un cycle alicyclique ou aromatique, mono- ou polycyclique, en (C3-C30) substitué ou non substitué, dont le ou les atomes de carbone peuvent être remplacés par au moins un hétéroatome sélectionné parmi l'azote, l'oxygène et le soufre ; 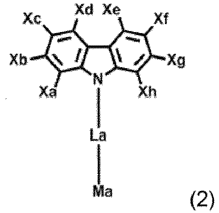
dans laquelle :
Ma représente un hétéroaryle de type à cycle monocyclique substitué ou non substitué sélectionné dans le groupe constitué d'un pyrrolyle substitué ou non substitué, d'un imidazolyle substitué ou non substitué, d'un pyrazolyle substitué ou non substitué, d'un triazinyle substitué ou non substitué, d'un tétrazinyle substitué ou non substitué, d'un triazolyle substitué ou non substitué, d'un tétrazolyle substitué ou non substitué, d'un pyrazinyle substitué ou non substitué, d'un pyrimidinyle substitué ou non substitué, et d'un pyridazinyle substitué ou non substitué, ou un hétéroaryle de type à cycle fusionné substitué ou non substitué sélectionné dans le groupe constitué d'un benzimidazolyle substitué ou non substitué, d'un isoindolyle substitué ou non substitué, d'un indolyle substitué ou non substitué, d'un indazolyle substitué ou non substitué, d'un benzothiadiazolyle substitué ou non substitué, d'un quinolyle substitué ou non substitué, d'un isoquinolyle substitué ou non substitué, d'un cinnolinyle substitué ou non substitué, d'un quinazolinyle substitué ou non substitué, d'un naphthyridinyle substitué ou non substitué et d'un quinoxalinyle substitué ou non substitué ;
La représente une liaison simple, ou un arylène en (C6-C30) substitué ou non substitué ;
Xa, et Xc à Xh, chacun indépendamment, représentent un atome d'hydrogène, un deutérium, un halogène, un cyano, un alkyle en (C1-C30) substitué ou non substitué, un alcényle en (C2-C30) substitué ou non substitué, un alcynyle en (C2-C30) substitué ou non substitué, un cycloalkyle en (C3-C30) substitué ou non substitué, un aryle en (C6-C60) substitué ou non substitué, un hétéroaryle à 3 à 30 éléments substitué ou non substitué, un tri-alkylsilyle en (C1-C30) substitué ou non substitué, un tri-arylsilyle en (C6-C30) substitué ou non substitué, un di-alkyle en (C1-C30)-arylsilyle en (C6-C30) substitué ou non substitué, un alkyle en (C1-C30)-di-arylsilyle en (C6-C30) substitué ou non substitué, ou un mono- ou di-arylamino en (C6-C30) substitué ou non substitué ;
Xb représente un dibenzofuranyle substitué ou non substitué ou un dibenzothiophényle substitué ou non substitué ; et
l'hétéroaryle contient au moins un hétéroatome sélectionné parmi B, N, O, S, Si, et P.

2. Dispositif électroluminescent organique selon la revendication 1, dans lequel dans la formule 1, A₁ et A₂, chacun indépendamment, sont sélectionnés dans le groupe constitué de : un phényle substitué ou non substitué, un biphényle substitué ou non substitué, un terphényle substitué ou non substitué, un naphtyle substitué ou non substitué, un fluorényle substitué ou non substitué, un benzofluorényle substitué ou non substitué, un phénanthrényle substitué ou non substitué, un anthracényle substitué ou non substitué, un indényle substitué ou non substitué, un triphénylényle substitué ou non substitué, un pyrényle substitué ou non substitué, un tétracényle substitué ou non substitué, un pérylényle substitué ou non substitué, un chrysényle substitué ou non substitué, un phénylnaphtyle substitué ou non substitué, un naphtylphényle substitué ou non substitué, et un fluoranthényle substitué ou non substitué.

3. Dispositif électroluminescent organique selon la revendication 1, dans lequel dans la formule 1, L₁ représente une liaison simple, ou une formule sélectionnée parmi les formules 7 à 19 suivantes : 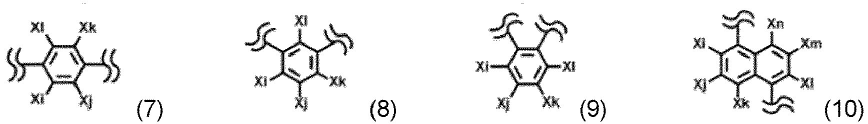 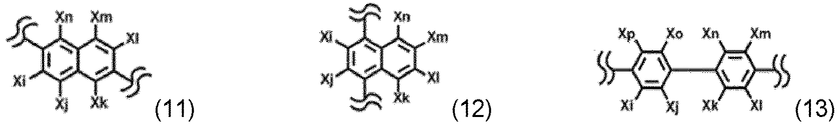 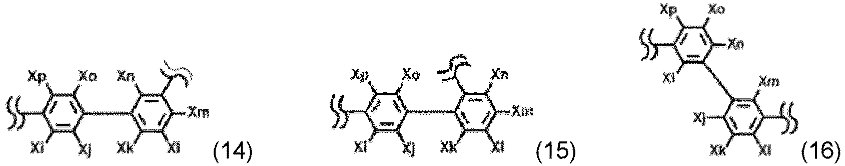 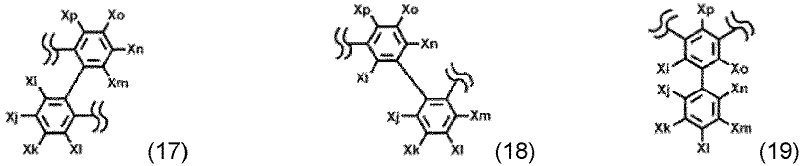 dans lesquelles :
Xi à Xp, chacun indépendamment, représentent un atome d'hydrogène, un deutérium, un halogène, un cyano, un alkyle en (C1-C30) substitué ou non substitué, un alcényle en (C2-C30) substitué ou non substitué, un alcynyle en (C2-C30) substitué ou non substitué, un cycloalkyle en (C3-C30) substitué ou non substitué, un aryle en (C6-C60) substitué ou non substitué, un hétéroaryle à 3 à 30 éléments substitué ou non substitué, un tri-alkylsilyle en (C1-C30) substitué ou non substitué, un tri-arylsilyle en (C6-C30) substitué ou non substitué, un di-alkyle en (C1-C30)-arylsilyle en (C6-C30) substitué ou non substitué, un alkyle en (C1-C30)-di-arylsilyle en (C6-C30) substitué ou non substitué, ou un mono- ou di-arylamino en (C6-C30) substitué ou non substitué ; ou ils peuvent être liés à un (des) substituant(s) adjacent(s) pour former un cycle alicyclique ou aromatique, mono- ou polycyclique en (C3-C30) substitué ou non substitué, dont le ou les atome(s) de carbone peuvent être remplacés par au moins un hétéroatome sélectionné parmi l'azote, l'oxygène et le soufre ; et 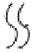 représente un site de liaison à un noyau mère.

4. Dispositif électroluminescent organique selon la revendication 1, dans lequel dans la formule 2, La représente une liaison simple ou une formule sélectionnée parmi les formules 7 à 19 : 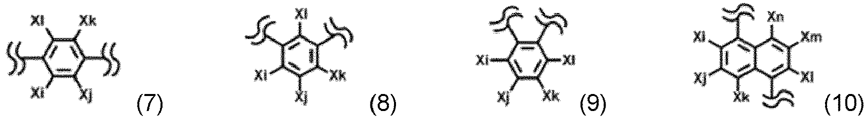 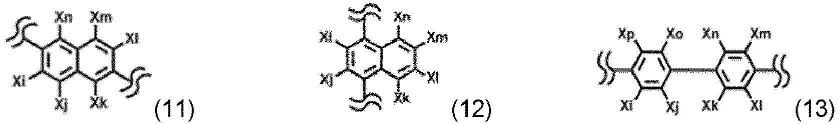 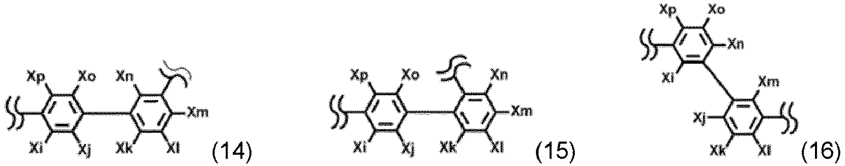 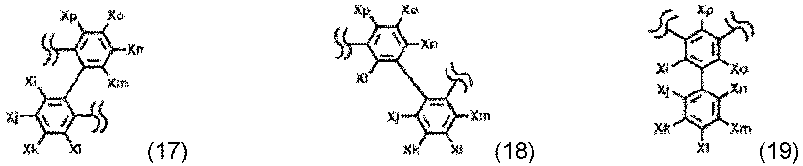 dans lesquelles :
Xi à Xp, chacun indépendamment, représentent un atome d'hydrogène, un deutérium, un halogène, un cyano, un alkyle en (C1-C30) substitué ou non substitué, un alcényle en (C2-C30) substitué ou non substitué, un alcynyle en (C2-C30) substitué ou non substitué, un cycloalkyle en (C3-C30) substitué ou non substitué, un aryle en (C6-C60) substitué ou non substitué, un hétéroaryle à 3 à 30 éléments substitué ou non substitué, un tri-alkylsilyle en (C1-C30) substitué ou non substitué, un tri-arylsilyle en (C6-C30) substitué ou non substitué, un di-alkyle en (C1-C30)-arylsilyle en (C6-C30) substitué ou non substitué, un alkyle en (C1-C30)-di-arylsilyle en (C6-C30) substitué ou non substitué, ou un mono- ou di-arylamino en (C6-C30) substitué ou non substitué ; ou ils peuvent être liés à un (des) substituant(s) adjacent(s) pour former un cycle alicyclique ou aromatique, mono- ou polycyclique en (C3-C30) substitué ou non substitué, dont le ou les atome(s) de carbone peuvent être remplacés par au moins un hétéroatome sélectionné parmi l'azote, l'oxygène et le soufre ; et 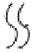 représente un site de liaison à un noyau mère.

5. Dispositif électroluminescent organique selon la revendication 1, dans lequel dans la formule 2, Xa et Xc à Xh, chacun indépendamment, représentent un atome d'hydrogène, un cyano, un aryle en (C6-C15) non substitué ou substitué par un tri-arylsilyle en (C6-C10), ou un hétéroaryle à 10 à 20 éléments non substitué ou substitué par un aryle en (C6-C12).

6. Dispositif électroluminescent organique selon la revendication 1, dans lequel le composé de formule 1 est sélectionné dans le groupe constitué de :

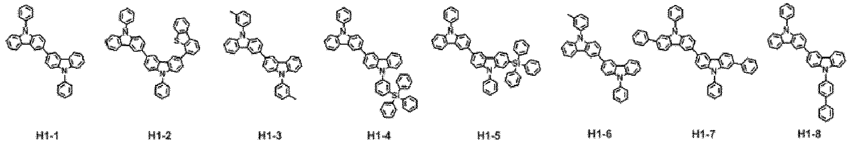

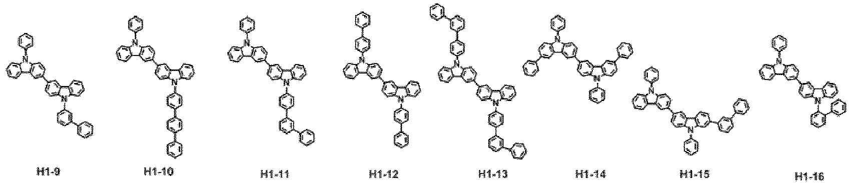

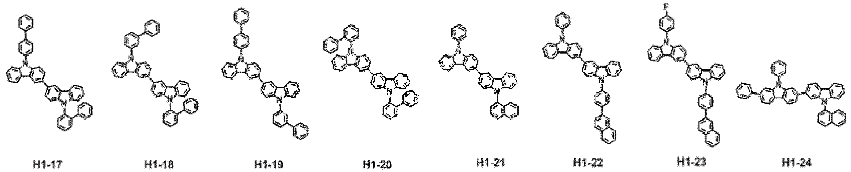

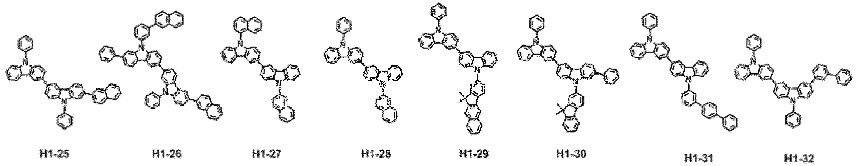

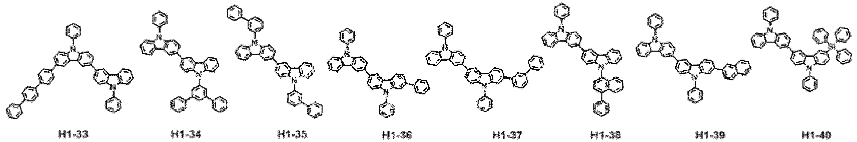

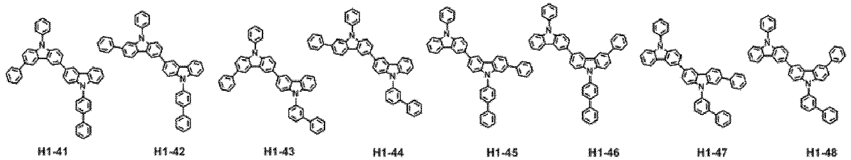

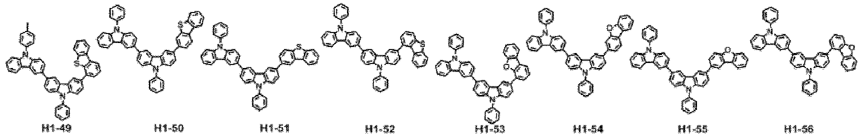

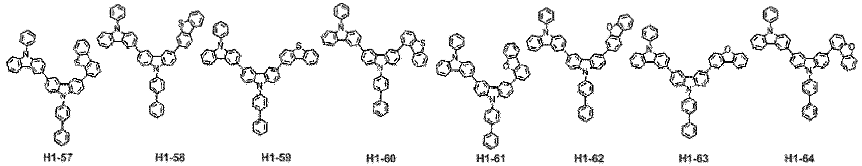

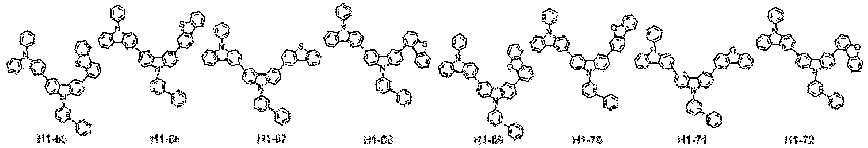

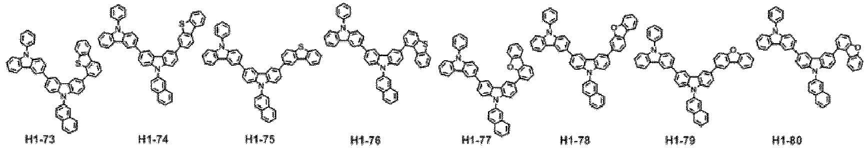

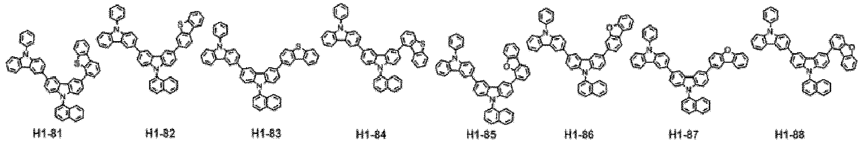

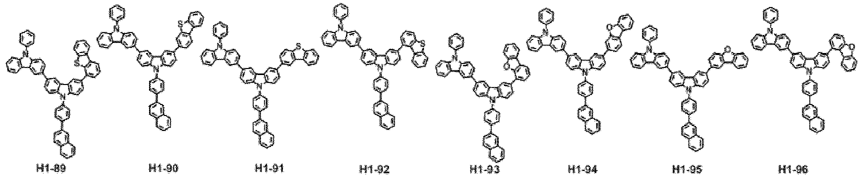

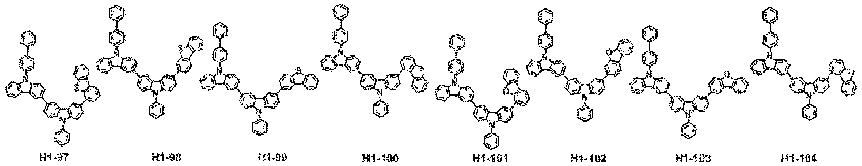

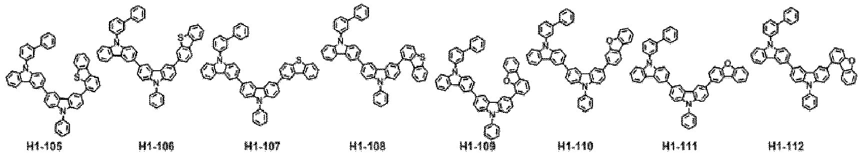

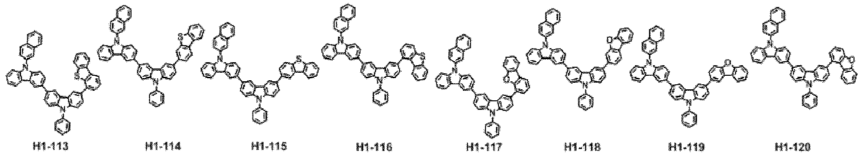

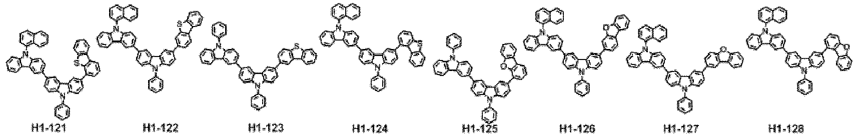

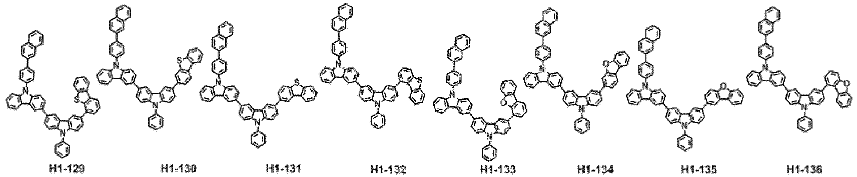

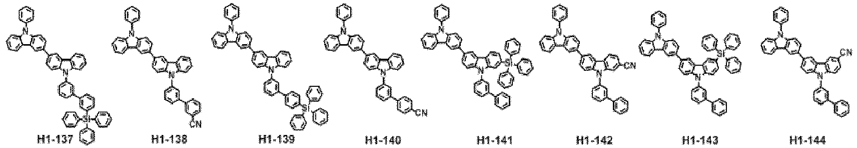

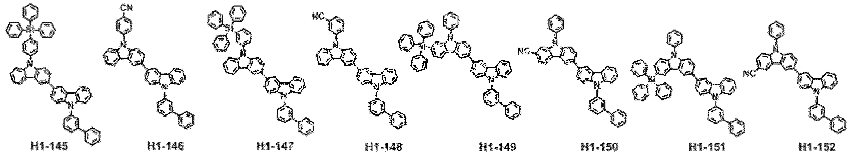

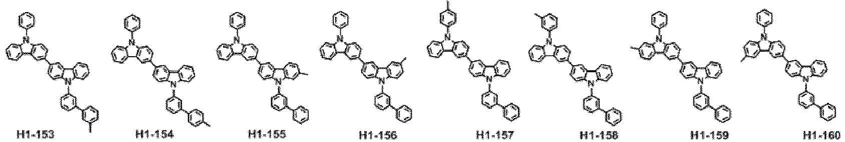

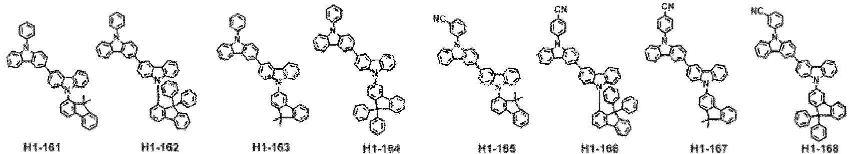

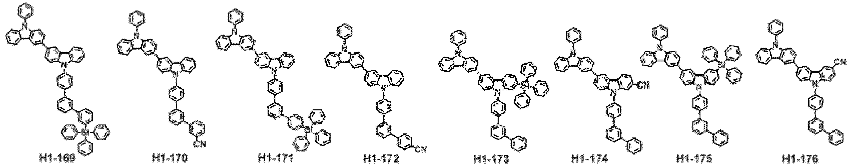

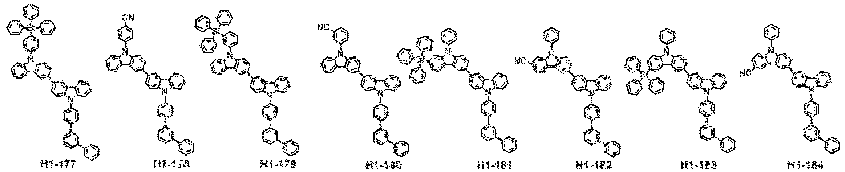

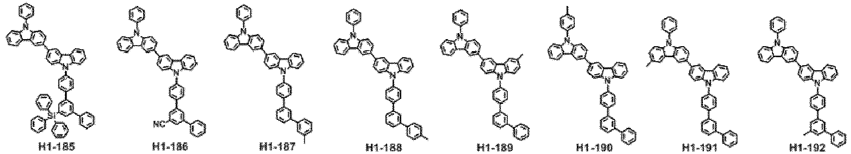

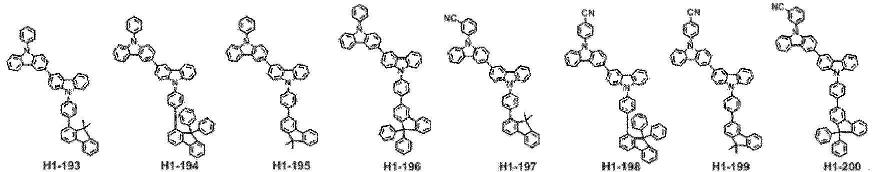

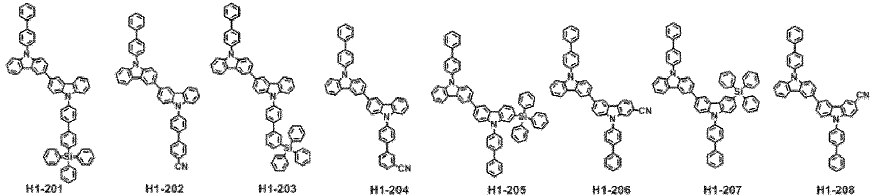

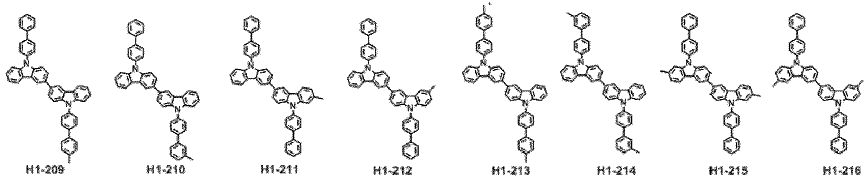

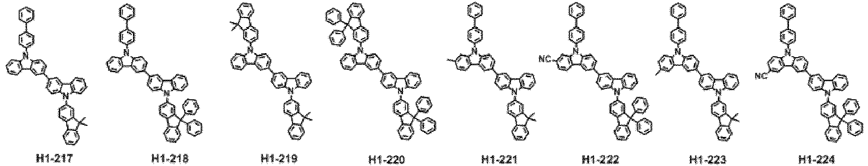

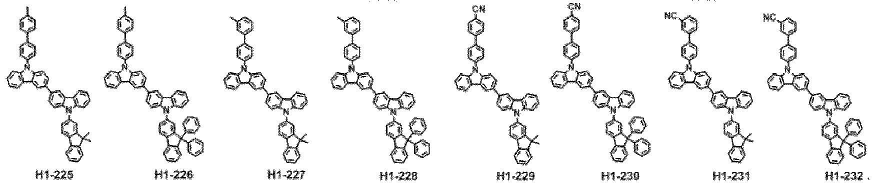

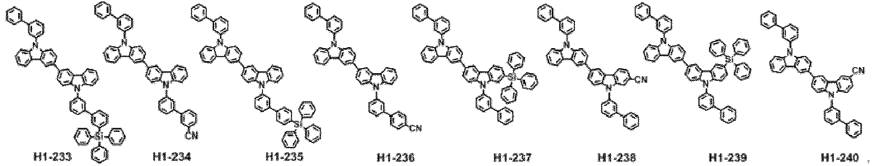

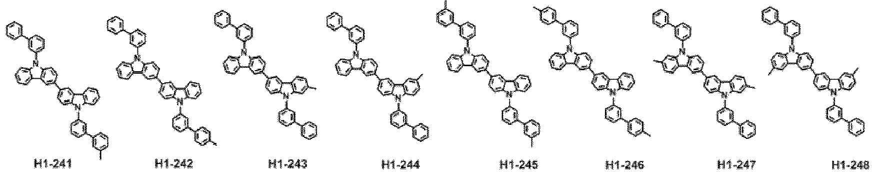

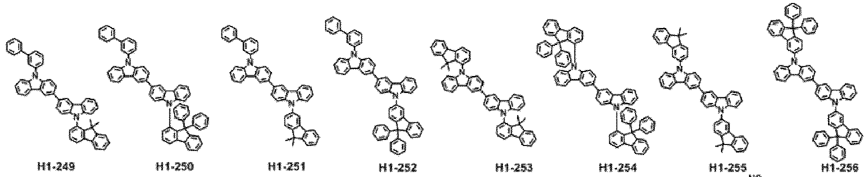

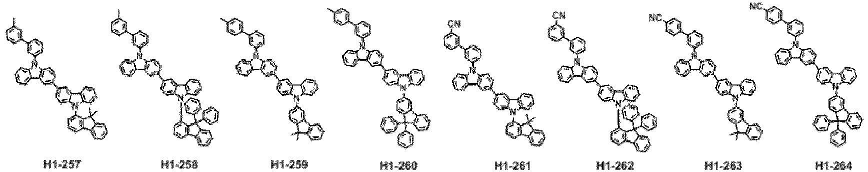

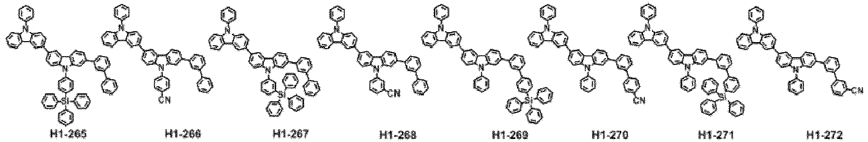

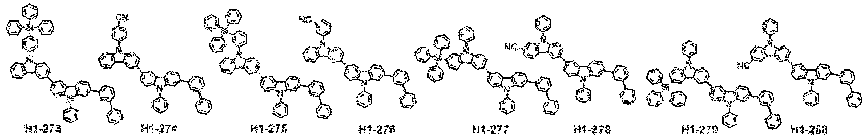

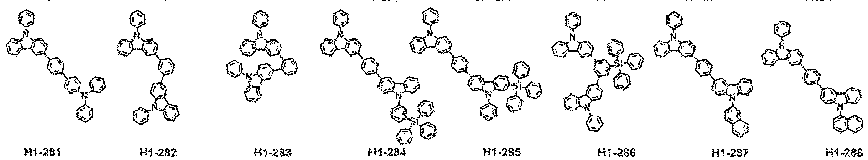

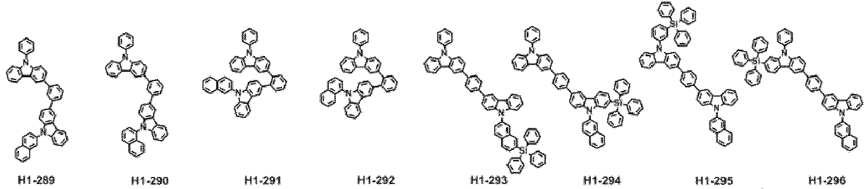

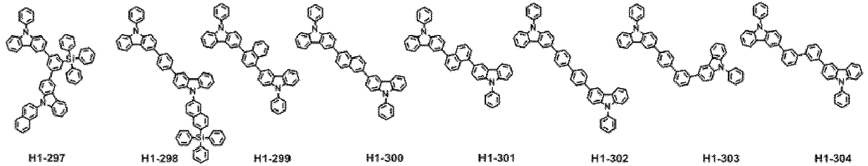

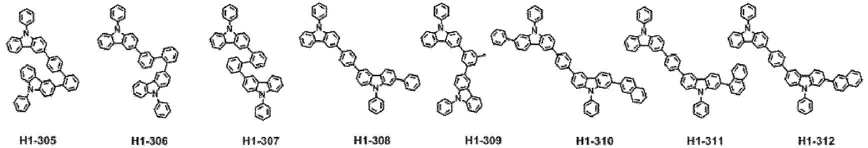

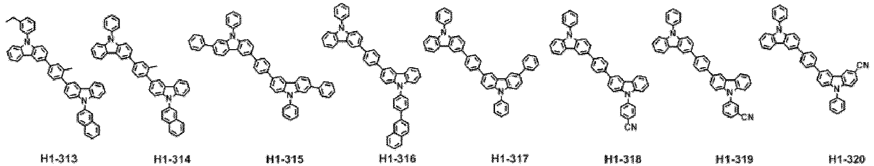

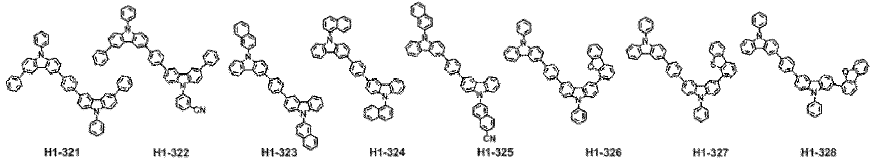

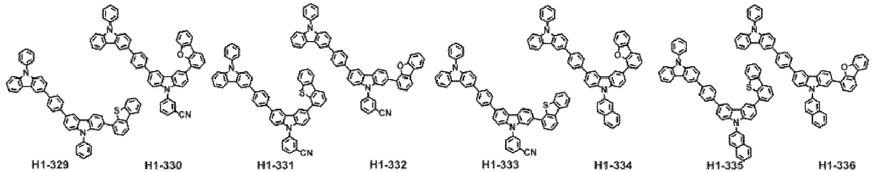

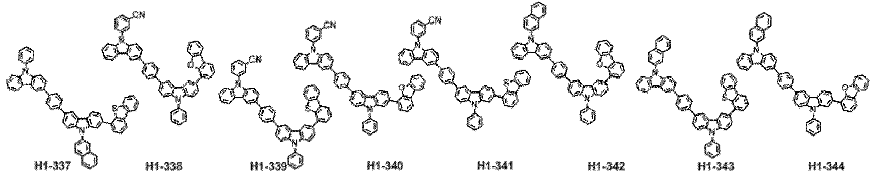

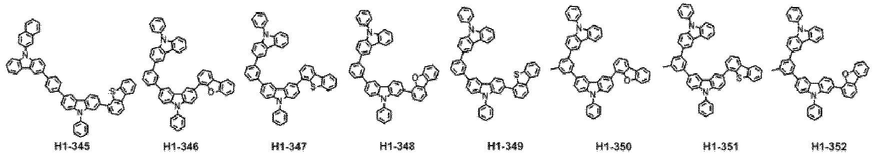

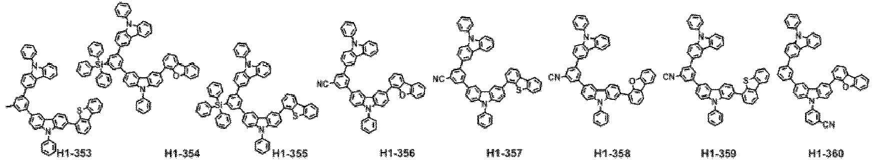

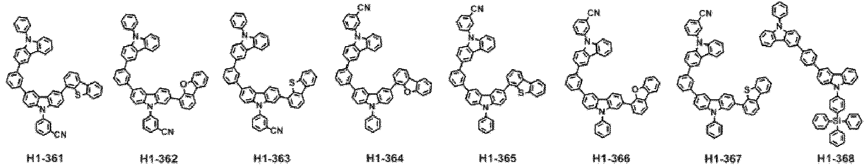

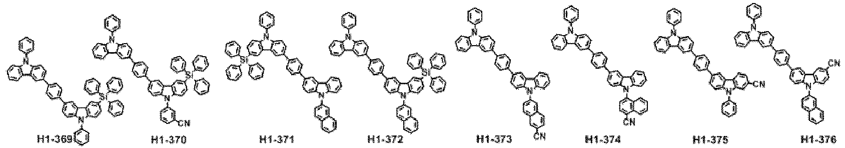

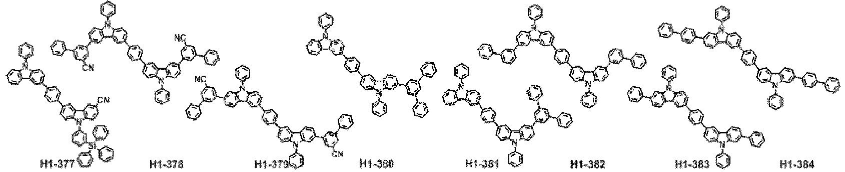

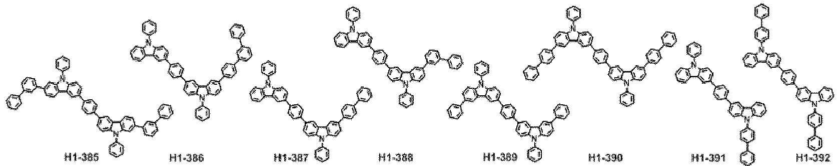

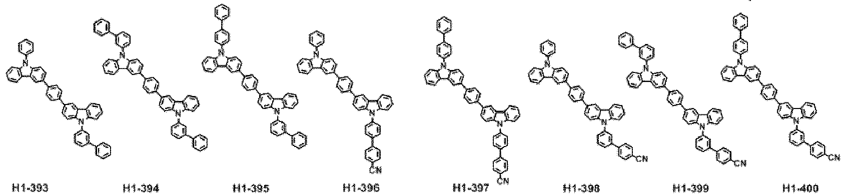

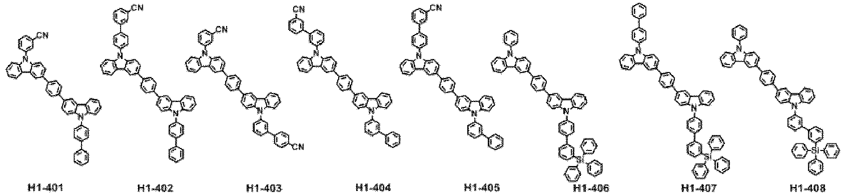

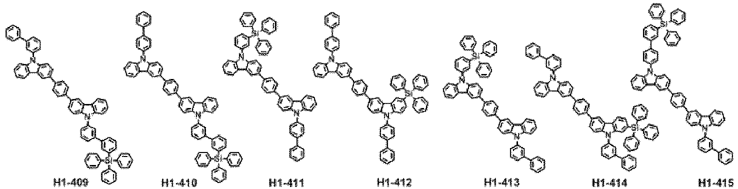

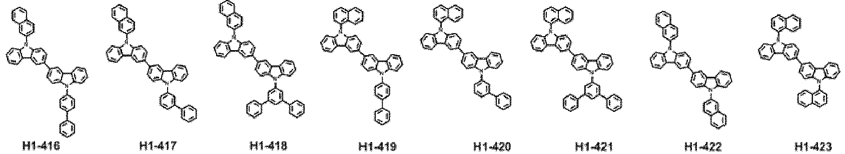

7. Dispositif électroluminescent organique selon la revendication 1, dans lequel le composé de formule 2 est sélectionné dans le groupe constitué de :
